# EUROPEAN PATENT APPLICATION

(11) **EP 4 236 082 A1**
(43) Date of publication of application: **30.08.2023**
(21) Application number: 21899977.9
(22) Date of filing: 29.11.2021
(51) Int. Cl.: H03M 13/25, H04L 1/00

(54) **CHANNEL CODING AND DECODING METHOD AND RELATED APPARATUS**

(30) Priority: 03.12.2020 CN 202011395003
(71) Applicant: Huawei Technologies Co., Ltd., Shenzhen, Guangdong 518129 (CN)
(72) Inventor: ZHANG, Huazi, Shenzhen, Guangdong 518129 (CN); MA, Jianglei, Ottawa, Ontario K2K3J1 (CA); WANG, Xianbin, Shenzhen, Guangdong 518129 (CN); LI, Rong, Shenzhen, Guangdong 518129 (CN); WANG, Jun, Shenzhen, Guangdong 518129 (CN)
(74) Representative: Maiwald GmbH
(86) International application number: PCT/CN2021/134115
(87) International publication number: WO 2022/116946

(57) **Abstract**

A channel coding/decoding method and a related apparatus are provided. The method includes: A first communication apparatus determines a first channel coding mode based on a first parameter, where the first parameter includes one or more of a coding parameter, a service type, a device type, a coding feature, a modulation and coding scheme, or a transport block size; and the first communication apparatus performs channel coding on a to-be-sent sequence by using the first channel coding mode, to obtain a coding sequence obtained after the channel coding, and sends the coding sequence. According to the channel coding/decoding method, an appropriate channel coding scheme can be adaptively and flexibly selected, to meet a requirement of a diversified channel coding/decoding scenario and a corresponding performance indicator, and provide flexibility for a protocol and a system.

## Description

This application claims priority to Chinese Patent Application No. 202011395003.1, filed with the China National Intellectual Property Administration on December 3, 2020 and entitled "CHANNEL CODING/DECODING METHOD AND RELATED APPARATUS", which is incorporated herein by reference in its entirety.

### TECHNICAL FIELD

This application relates to the field of communication technologies, and in particular, to a channel coding/decoding method and a related apparatus.

### BACKGROUND

Channel coding of a next generation mobile communication technology of a 5th generation mobile communication technology (5th generation mobile network or 5th generation wireless system, 5th Generation, 5G or 5G technology for short) is stronger in terms of performance indicators. In addition, with addition of various machine nodes and industrial applications, challenges are posed on requirements for various performance indicators of channel coding. In 5G, different coding schemes are used to meet different requirements. For example, channel coding is performed on a control channel by using a Polar code (Polar code), and channel coding is performed on a data channel by using a low-density parity-check code (Low-density parity-check code, LDPC code).

However, because application scenarios of 5G are greatly increased, how to determine a channel coding/decoding scheme is a problem that needs to be resolved.

### SUMMARY

Embodiments of this application provide a channel coding/decoding method and a related apparatus, to design a channel coding/decoding scheme, so that an appropriate channel coding scheme can be adaptively and flexibly selected, to meet a requirement of a diversified channel coding scenario and a corresponding performance indicator, and provide flexibility for a protocol and a system.

According to a first aspect, this application provides a channel coding method. The method includes: A first communication apparatus determines a first channel coding mode based on a first parameter, where the first parameter includes one or more of a coding parameter, a service type, a device type, a coding feature, a modulation and coding scheme, or a transport block size; and the first communication apparatus performs channel coding on a to-be-sent sequence by using the first channel coding mode, to obtain a coding sequence obtained after the channel coding, and sends the coding sequence.

In this solution, a mapping relationship between one or more of a coding parameter, a service type, a device type, a modulation and coding scheme, or a transport block size and a channel coding mode is defined, and then an appropriate channel coding mode is selected based on a current requirement of the communication apparatus, so that the appropriate channel coding mode can be adaptively and flexibly selected, to meet a requirement of a diversified channel coding scenario and a corresponding performance indicator, and provide flexibility for a protocol and a system.

Optionally, after determining the first channel coding mode, the first communication apparatus may send a first message, where the first message indicates the first channel coding mode. The first message may be a system broadcast message, a radio resource control message, downlink control information, uplink control information, sidelink control information, or the like.

In this solution, a mapping relationship between a channel coding mode and a coding parameter, a device type, a service type, or the like is defined, and the channel coding mode selected by a receive end and a transmit end is notified based on indication information, so that an appropriate channel coding mode can be adaptively and flexibly selected, to meet a requirement of a diversified channel coding/decoding scenario and a corresponding performance indicator, and provide flexibility for a protocol and a system.

With reference to the first aspect, in a possible design, the first parameter includes the coding parameter, and the coding parameter includes one or more of a code length, an information bit length, a latency, or an error floor. That a first communication apparatus determines a first channel coding mode based on a first parameter is specifically: The first communication apparatus determines the first channel coding mode based on a mapping relationship between a coding parameter and a channel coding mode and the coding parameter obtained by the first communication apparatus, where the coding parameter obtained by the first communication apparatus includes a code length determined by the first communication apparatus, an information bit length of the to-be-sent sequence, or a requirement of the first communication apparatus for the error floor or a size of the latency.

Optionally, the mapping relationship between a coding parameter and a channel coding mode includes at least one of the following cases: when a value of the coding parameter is less than or equal to a first coding parameter threshold, the channel coding mode is a first coding mode; when a value of the coding parameter is greater than the first coding parameter threshold and less than a second coding parameter threshold, the channel coding mode is a second coding mode; or when a value of the coding parameter is greater than or equal to the second coding parameter threshold, the channel coding mode is a third coding mode.

Optionally, if the coding parameter is the code length or the information bit length, the first coding mode is any one of a Reed-Muller code (Reed-Muller code, RM code for short), a BCH code (BCH code, Bose-Chaudhuri-Hocquenghem code), or a Reed-Solomon code (Reed-Solomon code, RS code for short); the second coding mode is a Polar code or a Turbo product code (Turbo product code, TPC)-Polar code (TPC-Polar code); and the third coding mode is any one of an LDPC code, a coupled LDPC code, or a coupled Polar code.

In this solution, different channel coding modes are designed based on different code lengths or information bit lengths, and a channel coding mode with excellent performance may be adaptively selected based on different to-be-sent sequences.

Optionally, if the coding parameter is the latency, and the latency is an end-to-end latency or a decoding latency, the first coding mode is an RM code or a BCH code; the second coding mode is a Polar code or an LDPC code; and the third coding mode is a Turbo code (Turbo code, Turbo code for short) or a Polar code.

In this solution, different channel coding modes are selected based on values of latencies, so that a requirement of the communication apparatus for the latency can be met.

Optionally, if the coding parameter is the error floor, the first coding mode is a Polar code or a BCH code; the second coding mode is an LDPC code; and the third coding mode is a Turbo code. It should be understood that the error floor may be used to reflect reliability. A smaller value of the error floor indicates higher reliability.

In this solution, different channel coding modes are selected based on sizes of error floors, so that a requirement of the communication apparatus for the reliability can be met.

With reference to the first aspect, in a possible design, the first parameter includes the service type, and the service type includes one or more of an enhanced mobile broadband (Enhanced Mobile Broadband, eMBB) service, an ultra-reliable low-latency communication (Ultra-Reliable Low-Latency Communication, URLLC) service, a massive machine type communication (massive Machine Type Communication, mMTC) service, an ultra high throughput service, an autonomous driving service, or an industrial network service. That a first communication apparatus determines a first channel coding mode based on a first parameter is specifically: The first communication apparatus determines the first channel coding mode based on a mapping relationship between a service type and a channel coding mode and a service type to which the to-be-sent sequence belongs.

Optionally, the mapping relationship between a service type and a channel coding mode includes at least one of the following cases: when the service type is the eMBB service, the channel coding mode is an LDPC code or a Polar code; when the service type is the URLLC service, the channel coding mode is a BCH-Polar code or a Golay code Golay code; when the service type is the mMTC service, the channel coding mode is any one of a tail-biting convolutional code (Tail-biting convolutional code, TBCC code for short), a Polar code, or a BCH code; when the service type is the ultra high throughput service, the channel coding mode is any one of a TPC-Polar code, a Grr-coset code, or an LDPC code; when the service type is the autonomous driving service, the channel coding mode is a BCH-Polar code; or when the service type is the industrial network service, the channel coding mode is any one of an RM code, a BCH code, or an RS code.

In this solution, a corresponding channel coding mode is selected based on a service type to which the to-be-sent sequence belongs, so that requirements of different services for bandwidth, reliability, a latency, a throughput, power consumption, or the like can be met.

With reference to the first aspect, in a possible design, the first parameter includes the device type. Before that a first communication apparatus determines a first channel coding mode based on a first parameter, the method further includes: The first communication apparatus receives a second message, where the second message indicates a device type of a second communication apparatus. That a first communication apparatus determines a first channel coding mode based on a first parameter is specifically: The first communication apparatus determines, based on a mapping relationship between a device type and a channel coding mode, the first channel coding mode corresponding to a device type of the first communication apparatus.

Optionally, the mapping relationship between a device type and a channel coding mode includes at least one of the following cases: when the device type is an active device, the channel coding mode is an LDPC code or a Polar code; when the device type is a passive device, the channel coding mode is a short sequence or a short cyclic code; when the device type is a low power consumption device, the channel coding mode is any one of a TBCC, a Polar code, or a BCH code; when the device type is a high throughput device, the channel coding mode is any one of a TPC-Polar code, a G_{N}-coset code, or an LDPC code; when the device type is a high-reliable device, the channel coding mode is any one of a Polar code, a BCH code, or an RS code; or when the device type is a low-latency device, the channel coding mode is any one of a Polar code, a BCH code, an RS code, or an LDPC code.

In this solution, different channel coding modes are selected based on device types to meet requirements of different devices.

With reference to the first aspect, in a possible design, the first parameter includes the coding feature. The method further includes: receiving a third message, where the third message indicates a coding feature supported by a second communication apparatus, and the coding feature includes one or more of a hybrid automatic repeat request (hybrid automatic repeat request, HARQ), an outer erasure code, or network coding. That a first communication apparatus determines a first channel coding mode based on a first parameter is specifically: The first communication apparatus generates, based on the coding feature supported by the second communication apparatus, the first channel coding mode that meets the coding feature. In this solution, a channel coding mode that meets a condition may be adaptively generated.

With reference to the first aspect, in a possible design, the first parameter includes the modulation and coding scheme (Modulation and Coding Scheme, MCS) or the transport block size (Transport Block Size, TBS). That a first communication apparatus determines a first channel coding mode based on a first parameter is specifically: The first communication apparatus determines the first channel coding mode based on a mapping relationship between an MCS index or a TBS index and a channel coding mode and an MCS index or a transport block size index determined by the first communication apparatus.

Optionally, the first message is the MCS index or the TBS index.

Optionally, the mapping relationship between an MCS index or a TBS index and a channel coding mode includes at least one of the following cases: when the MCS index or the TBS index is in a first interval, the channel coding mode is any one of a Simplex Simplex code, an RM code, or a BCH code; when the MCS index or the TBS index is in a second interval, the channel coding mode is a TBCC or a BCH-Polar code; when the MCS index or the TBS index is in a third interval, the channel coding mode is a Polar code; when the MCS index or the TBS index is in a fourth interval, the channel coding mode is an LDPC code; or when the MCS index or the TBS index is in a fifth interval, the channel coding mode is a TPC-Polar code or a coupled Polar code, where
the first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval.

According to a second aspect, this application provides a channel decoding method. The method includes: A second communication apparatus receives a coding sequence; the second communication apparatus obtains a first channel coding mode, where the first channel coding mode is determined based on a first parameter, and the first parameter includes one or more of a coding parameter, a service type, a device type, a coding feature, a modulation and coding scheme, or a transport block size; and the second communication apparatus performs channel decoding on the coding sequence by using the first channel coding mode, to obtain a sequence obtained after the channel decoding.

Optionally, that the second communication apparatus obtains a first channel coding mode is specifically: The second communication apparatus receives a first message, where the first message indicates the first channel coding mode.

With reference to the second aspect, in a possible design, the first parameter includes the coding parameter, and the coding parameter includes one or more of a code length, an information bit length, a latency, or an error floor. That the second communication apparatus obtains a first channel coding mode is specifically: The second communication apparatus determines the first channel coding mode based on a mapping relationship between a coding parameter and a channel coding mode and the coding parameter obtained by the second communication apparatus, where the coding parameter obtained by the second communication apparatus includes a code length of the coding sequence, an information bit length of a to-be-sent sequence, or a requirement of a first communication apparatus for the error floor or a size of the latency; and determines the first channel coding mode.

Optionally, the mapping relationship between a coding parameter and a channel coding mode includes at least one of the following cases: when a value of the coding parameter is less than or equal to a first coding parameter threshold, the channel coding mode is a first coding mode; when a value of the coding parameter is greater than the first coding parameter threshold and less than a second coding parameter threshold, the channel coding mode is a second coding mode; or when a value of the coding parameter is greater than or equal to the second coding parameter threshold, the channel coding mode is a third coding mode.

Optionally, if the coding parameter is the code length or the information bit length, the first coding mode is any one of a Reed-Muller RM code, a BCH code, or a Reed-Solomon RS code; the second coding mode is a Polar Polar code or a Turbo product code-Polar code TPC-Polar code; and the third coding mode is any one of a low-density parity-check code LDPC code, a coupled LDPC code, or a coupled Polar code.

Optionally, if the coding parameter is the latency, and the latency is an end-to-end latency or a decoding latency, the first coding mode is an RM code or a BCH code; the second coding mode is a Polar code or an LDPC code; and the third coding mode is a Turbo code Turbo code or a Polar code.

Optionally, if the coding parameter is the error floor, the first coding mode is a Polar code or a BCH code; the second coding mode is an LDPC code; and the third coding mode is a Turbo code.

With reference to the second aspect, in a possible design, the first parameter includes the service type, and the service type includes one or more of an eMBB service, an URLLC service, an mMTC service, an ultra high throughput service, an autonomous driving service, or an industrial network service. That the second communication apparatus obtains a first channel coding mode is specifically: The second communication apparatus determines the first channel coding mode based on a mapping relationship between a service type and a channel coding mode and a service type to which the coding sequence belongs.

Optionally, the mapping relationship between a service type and a channel coding mode includes at least one of the following cases: when the service type is the eMBB service, the channel coding mode is an LDPC code or a Polar code; when the service type is the URLLC service, the channel coding mode is a BCH-Polar code or a Golay code Golay code; when the service type is the mMTC service, the channel coding mode is any one of a tail-biting convolutional code TBCC, a Polar code, or a BCH code; when the service type is the ultra high throughput service, the channel coding mode is any one of a TPC-Polar code, a GN-coset code, or an LDPC code; when the service type is the autonomous driving service, the channel coding mode is a BCH-Polar code; or when the service type is the industrial network service, the channel coding mode is any one of an RM code, a BCH code, or an RS code.

With reference to the second aspect, in a possible design, the first parameter includes the device type. The method further includes: The second communication apparatus sends a second message, where the second message indicates a device type of the second communication apparatus. That the second communication apparatus obtains a first channel coding mode is specifically: determining, based on a mapping relationship between a device type and a channel coding mode, the first channel coding mode corresponding to a device type of the first communication apparatus.

Optionally, the mapping relationship between a device type and a channel coding mode includes at least one of the following cases: when the device type is an active device, the channel coding mode is an LDPC code or a Polar code; when the device type is a passive device, the channel coding mode is a short sequence or a short cyclic code; when the device type is a low power consumption device, the channel coding mode is any one of a TBCC, a Polar code, or a BCH code; when the device type is a high throughput device, the channel coding mode is any one of a TPC-Polar code, a G_{N}-coset code, or an LDPC code; when the device type is a high-reliable device, the channel coding mode is any one of a Polar code, a BCH code, or an RS code; or when the device type is a low-latency device, the channel coding mode is any one of a Polar code, a BCH code, an RS code, or an LDPC code.

With reference to the second aspect, in a possible design, the first parameter includes the coding feature. The method further includes: The second communication apparatus sends a third message, where the third message indicates a coding feature supported by the second communication apparatus, and the coding feature includes one or more of a HARQ, an outer erasure code, or network coding. That the second communication apparatus obtains a first channel coding mode is specifically: The second communication apparatus generates, based on the coding feature supported by the second communication apparatus, the first channel coding mode that meets the coding feature.

With reference to the second aspect, in a possible design, the first parameter includes the MCS or the TBS. That the second communication apparatus obtains a first channel coding mode is specifically: The second communication apparatus determines the first channel coding mode based on a mapping relationship between an MCS index or a TBS index and a channel coding mode and an MCS or a transport block size indicated by a first communication apparatus.

Optionally, the first message is the MCS index or the TBS index.

Optionally, the mapping relationship between an MCS index or a TBS index and a channel coding mode includes at least one of the following cases: when the MCS index or the TBS index is in a first interval, the channel coding mode is any one of a Simplex Simplex code, an RM code, or a BCH code; when the MCS index or the TBS index is in a second interval, the channel coding mode is a TBCC or a BCH-Polar code; when the MCS index or the TBS index is in a third interval, the channel coding mode is a Polar code; when the MCS index or the TBS index is in a fourth interval, the channel coding mode is an LDPC code; or when the MCS index or the TBS index is in a fifth interval, the channel coding mode is a TPC-Polar code or a coupled Polar code, where
the first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval.

According to a third aspect, this application provides a first communication apparatus. The first communication apparatus may be a communication device or a chip or a circuit that may be disposed in the communication device. The first communication apparatus includes units and/or modules configured to perform the channel coding method provided in any one of the first aspect and/or the possible implementations of the first aspect. Therefore, beneficial effects (or advantages) of the channel coding method provided in the first aspect can also be implemented.

In a possible implementation, the first communication apparatus includes a determining module, a channel coding module, and a transceiver module.

The determining module is configured to determine a first channel coding mode based on a first parameter, where the first parameter includes one or more of a coding parameter, a service type, a device type, a coding feature, a modulation and coding scheme MCS, or a transport block size TBS;
the channel coding module is configured to perform channel coding on a to-be-sent sequence by using the first channel coding mode, to obtain a coding sequence obtained after the channel coding; and
the transceiver module is configured to send the coding sequence.

Optionally, the modules of the first communication apparatus are further configured to perform the channel coding method in any possible implementation of the first aspect. Details are not described herein again.

According to a fourth aspect, this application provides a second communication apparatus. The second communication apparatus may be a communication device or a chip or a circuit that may be disposed in the communication device. The second communication apparatus includes units and/or modules configured to perform the channel decoding method provided in any one of the second aspect and/or the possible implementations of the second aspect. Therefore, beneficial effects (or advantages) of the channel decoding method provided in the second aspect can also be implemented.

In a possible implementation, the second communication apparatus includes a transceiver module, an obtaining module, and a channel decoding module.

The transceiver module is configured to receive a coding sequence;
the obtaining module is configured to obtain a first channel coding mode, where the first channel coding mode is determined based on a first parameter, and the first parameter includes one or more of a coding parameter, a service type, a device type, a coding feature, a modulation and coding scheme MCS, or a transport block size TBS; and
the channel decoding module is configured to perform channel decoding on the coding sequence by using the first channel coding mode, to obtain a sequence obtained after the channel decoding.

Optionally, the modules of the second communication apparatus are further configured to perform the channel decoding method in any possible implementation of the second aspect. Details are not described herein again.

According to a fifth aspect, this application provides a communication apparatus. The communication apparatus may include a processor, a transceiver, and a memory. The memory is configured to store a computer program. The transceiver is configured to receive and send various signals. The computer program includes program instructions. When the processor runs the program instructions, the communication apparatus is enabled to perform the channel coding method in any one of the first aspect or the possible implementations of the first aspect. Alternatively, when the processor runs the program instructions, the communication apparatus is enabled to perform the channel decoding method in any one of the second aspect or the possible implementations of the second aspect. The transceiver may be a radio frequency module in the communication apparatus, a combination of a radio frequency module and an antenna, or an input/output interface of a chip or a circuit.

According to a sixth aspect, this application provides a computer-readable storage medium. The computer-readable storage medium stores program instructions. When the program instructions are run on a computer, the computer is enabled to perform the channel coding method in any one of the first aspect or the possible implementations of the first aspect. Alternatively, when the program instructions are run on a computer, the computer is enabled to perform the channel decoding method in any one of the second aspect or the possible implementations of the second aspect.

According to a seventh aspect, this application provides a program product including program instructions. When the program product runs, the channel coding method described in any one of the first aspect or the possible implementations of the first aspect is performed. Alternatively, when the program product runs, the channel decoding method described in any one of the second aspect or the possible implementations of the second aspect is performed.

According to an eighth aspect, an embodiment of this application provides an apparatus. The apparatus is implemented in a form of a chip, and the apparatus includes a processor. The processor is configured to read and execute a program stored in a memory, to perform the method provided in any one or more of the first aspect and the second aspect or the possible implementations of the first aspect or the second aspect. Optionally, the apparatus further includes the memory, and the memory is connected to the processor through a circuit or an electric wire. Further, optionally, the apparatus further includes a communication interface, and the processor is connected to the communication interface. The communication interface is configured to receive data and/or information that need/needs to be processed. The processor obtains the data and/or the information from the communication interface, processes the data and/or the information, and outputs a processing result through the communication interface. The communication interface may be an input/output interface.

Optionally, the processor and the memory may be physically independent units, or the memory may be integrated with the processor.

According to embodiments of this application, an appropriate channel coding scheme can be adaptively and flexibly selected, to meet a requirement of a diversified channel coding scenario and a corresponding performance indicator, and provide flexibility for a protocol and a system.

### BRIEF DESCRIPTION OF DRAWINGS

To describe technical solutions in embodiments of this application more clearly, the following briefly describes the accompanying drawings used for describing the embodiments.
FIG. 1 is a schematic diagram of a system architecture of a wireless communication system according to an embodiment of this application;
FIG. 2 is a block diagram of a communication system according to an embodiment of this application;
FIG. 3 is a schematic flowchart of a channel coding/decoding method according to an embodiment of this application;
FIG. 4 is a schematic diagram of a structure of a first communication apparatus according to an embodiment of this application;
FIG. 5 is a schematic diagram of a structure of a second communication apparatus according to an embodiment of this application; and
FIG. 6 is a schematic diagram of a structure of a communication device according to an embodiment of this application.

### DESCRIPTION OF EMBODIMENTS

The following clearly and completely describes the technical solutions in embodiments of this application with reference to the accompanying drawings in embodiments of this application.

For ease of understanding a channel coding method provided in embodiments of this application, the following describes a system architecture of the channel coding method provided in embodiments of this application. It may be understood that the system architecture described in embodiments of this application is intended to describe the technical solutions in embodiments of this application more clearly, and do not constitute any limitation on the technical solutions provided in embodiments of this application.

The channel coding method provided in embodiments of this application may be applied to a wireless communication system. The wireless communication system mentioned in embodiments of this application includes but is not limited to a narrowband Internet of Things (Narrowband Internet of Things, NB-IoT) system, a long term evolution (Long Term Evolution, LTE) system, three application scenarios of a 5G mobile communication system, namely, enhanced mobile broadband (Enhanced Mobile Broadband, eMBB), ultra-reliable low-latency communication (Ultra-Reliable Low-Latency Communication, URLLC), and enhanced machine type communication (LTE enhanced MTC, eMTC), and a next generation communication system of 5G such as a 6th generation (6th generation, 6G) mobile communication system. This is not limited in this application.

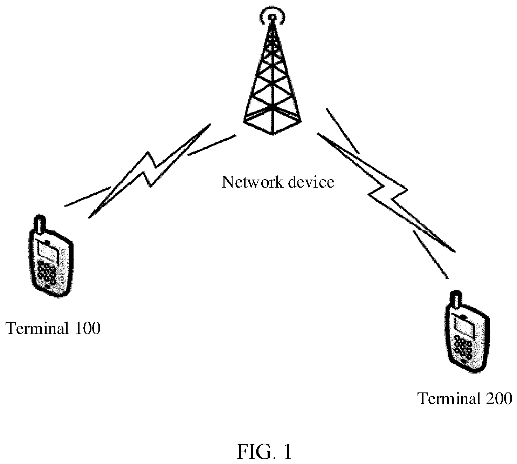

FIG. 1 is a schematic diagram of a system architecture of a wireless communication system according to an embodiment of this application. As shown in FIG. 1, the wireless communication system may include at least one network device and at least one terminal (for example, a terminal 100 and a terminal 200 in FIG. 1). The terminal may be connected to the network device in a wireless manner. Both the terminal and the network device support 5G and a next generation mobile communication technology of 5G. The network device is an entity configured to transmit or receive a signal on a network side, and the terminal is an entity, for example, a mobile phone, configured to receive or transmit a signal on a user side. Optionally, FIG. 1 is only a schematic diagram. The wireless communication system may alternatively include another device, for example, may alternatively include a core network device, a wireless relay device, and/or a wireless backhaul device. This is not shown in FIG. 1.

Optionally, during actual application, the wireless communication system may include a plurality of network devices, or may include a plurality of terminals. One network device may serve one or more terminals at the same time. One terminal may also access one or more network devices at the same time. Quantities of terminals and network devices included in the wireless communication system are not limited in embodiments of this application.

Optionally, a channel coding method provided in embodiments of this application may be applied to a network device, or may be applied to various terminal devices.

The terminal in embodiments of this application may be user equipment (user equipment, UE), a smartphone, a tablet computer (Pad), a vehicle-mounted mobile apparatus, a mobile station (mobile station, MS), a remote terminal, a personal digital assistant (personal digital assistant, PDA), a wearable device, a virtual reality (Virtual Reality, VR)/augmented reality (augmented reality, AR) device, various Internet of Things (Internet of Things, IoT) devices, a wireless device in industrial control (industrial control), a wireless device in self driving (self driving), a wireless device in telemedicine (telemedicine), a wireless device in a smart grid (smart grid), a wireless device in transportation safety (transportation safety), a wireless device in a smart city (smart city), a wireless device in a smart home (smart home), a terminal device in a future wireless communication system, or the like; or may be used in a dedicated network device or a general-purpose device.

The network device in embodiments of this application may be an evolved NodeB (evolved NodeB, "eNB" or "eNodeB" for short) in an LTE system or a network side device (for example, a gNB) in a 5G network; or the network device may be a relay station, an access point, a transmission reception point (transmission reception point, TRP), a transmission point (transmission point, TP), a mobile switching center, a device that bears a base station function in device-to-device (Device-to-Device, D2D), vehicle-to-everything (vehicle-to-everything, V2X), or machine-to-machine (machine-to-machine, M2M) communication, a network side device in a 6G network, a device that bears a base station function in a future communication system, or the like.

Embodiments of this application provide a channel coding/decoding method. Mapping relationships between channel coding modes and various parameters (for example, a coding parameter, a service type, a device type, a coding feature, a modulation and coding scheme, or a transport block size) are designed, and these mapping relationships are protocol-defined. Alternatively, a transmit end notifies, based on indication information, a receive end of a channel coding mode selected by the transmit end, so that a communication process between the transmit end and the receive end can be implemented. In another aspect, in the channel coding method, an appropriate channel coding scheme can be adaptively and flexibly selected, to meet a requirement of a diversified channel coding scenario and a corresponding performance indicator in a next generation mobile communication system such as 6G of 5G, and provide flexibility for a protocol and a system.

The following describes in detail the signal processing method provided in this application with reference to more accompanying drawings.

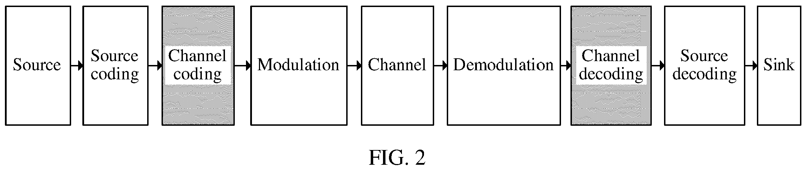

The technical solutions provided in embodiments of this application focus on a channel coding part and a channel decoding part in the communication process. Specifically, FIG. 2 is a block diagram of a communication system according to an embodiment of this application. As shown in FIG. 2, at a transmit end, operations such as source coding, channel coding, and modulation are sequentially performed on a data stream generated by a source, to obtain a to-be-sent signal. The signal is transmitted to a receive end through a channel. At the receive end, after operations such as demodulation, channel decoding, and source decoding are sequentially performed on the received signal, the data stream is obtained and arrives at a sink. A channel coding process and a channel decoding process may be implemented through a dedicated chip such as an application-specific integrated circuit (application-specific integrated circuit, ASIC), or a programmable chip such as a field-programmable gate array (field-programmable gate array, FPGA); or may be implemented through software (program code in a memory).

It may be understood that in embodiments of this application, a first communication apparatus may be a network device, and a second communication apparatus may be a terminal.

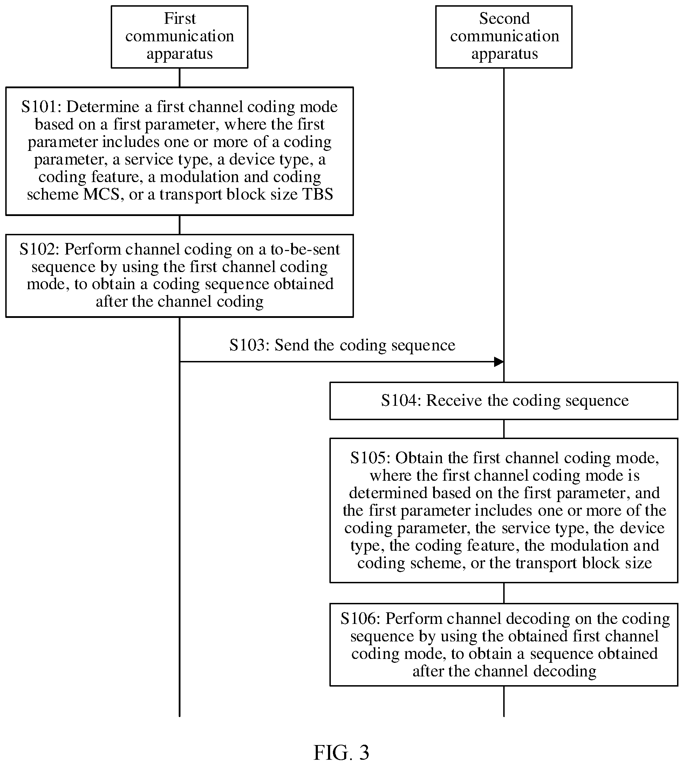

FIG. 3 is a schematic flowchart of a channel coding/decoding method according to an embodiment of this application. As shown in FIG. 3, the channel coding method includes but is not limited to the following steps.

S101: A first communication apparatus determines a first channel coding mode based on a first parameter, where the first parameter includes one or more of a coding parameter, a service type, a device type, a coding feature, a modulation and coding scheme (Modulation and Coding Scheme, MCS), or a transport block size (Transport Block Size, TBS).

Specifically, the first communication apparatus determines the first channel coding mode based on one or more of the first parameter, a mapping relationship between a first parameter and a channel coding mode, and a to-be-sent sequence. The first parameter includes one or more of the coding parameter, the service type, the device type, the coding feature, the modulation and coding scheme MCS, or the transport block size TBS.

Optionally, after determining the first channel coding mode, the first communication apparatus may send a first message to a second communication apparatus, where the first message indicates the first channel coding mode. The first message may be a system message (System Information Block, SIB), for example, a SIB 1 or a SIB 2, or may be a radio resource control (Radio Resource Control, RRC) message, downlink control information (Downlink Control Information, DCI), or uplink control information (uplink Control Information, UCI), or may be sidelink control information (sidelink control information, SCI) of a sidelink in a D2D or V2X scenario, or the like.

S102: The first communication apparatus performs channel coding on the to-be-sent sequence by using the first channel coding mode, to obtain a coding sequence obtained after the channel coding.

Specifically, after determining the first channel coding mode, the first communication apparatus performs channel coding on the to-be-sent sequence by using the first channel coding mode, to obtain the coding sequence obtained after the channel coding. The to-be-sent sequence herein is a sequence obtained after performing source coding on a data stream generated by a source. For example, if the first channel coding mode is a Polar code, channel coding is performed on the to-be-sent sequence by using the Polar code; or if the first channel coding mode is a BCH code, channel coding is performed on the to-be-sent sequence by using the BCH code.

S103: The first communication apparatus sends the coding sequence.

Specifically, the first communication apparatus modulates the coding sequence and then sends the coding sequence.

S104: The second communication apparatus receives the coding sequence.

Specifically, the second communication apparatus demodulates a received signal to obtain the coding sequence.

S105: The second communication apparatus obtains the first channel coding mode, where the first channel coding mode is determined based on the first parameter, and the first parameter includes one or more of the coding parameter, the service type, the device type, the coding feature, the modulation and coding scheme, or the transport block size.

Specifically, there are two implementations in which the second communication apparatus obtains the first channel coding mode. In one implementation, the second communication apparatus receives the first message sent by the first communication apparatus, where the first message indicates the first channel coding mode. In the other implementation, the second communication apparatus determines the first channel coding mode based on the first parameter, where the first parameter includes one or more of the coding parameter, the service type, the device type, the coding feature, the modulation and coding scheme MCS, or the transport block size TBS. For this implementation, refer to descriptions in step S101. Details are not described herein again.

It may be understood that when the first parameter includes the coding parameter, and the coding parameter is information bit length, the first communication apparatus notifies the second communication apparatus of the information bit length of the to-be-sent sequence by using signaling or a message (where it should be understood that the information bit length is notified herein, and content of the to-be-sent sequence needs to be obtained after the second communication apparatus performs operations such as channel decoding and demodulation on the coding sequence).

It may be understood that when the first parameter includes the MCS or the TBS, the first communication apparatus may notify the first communication apparatus of a determined MCS index or TBS index by using DCI or UCI, and the second communication apparatus determines the first channel coding mode based on a mapping relationship between an MCS index or a TBS index and a channel coding mode and an MCS index or a TBS index indicated by the first communication apparatus.

S106: The second communication apparatus performs channel decoding on the coding sequence by using the obtained first channel coding mode, to obtain a sequence obtained after the channel decoding.

Specifically, after obtaining the first channel coding mode, the second communication apparatus performs channel decoding on the coding sequence by using the first channel coding mode, to obtain the sequence obtained after the channel decoding. A transmit end performs channel coding by using the first channel coding mode, and a receive end performs channel decoding in a same mode. Therefore, a sequence obtained by the receive end through channel decoding is consistent with a to-be-sent sequence of the receive end, so that normal communication between the transmit end and the receive end is implemented. For example, if the first channel coding mode is an RM code, channel decoding is performed on the coding sequence by using the RM code; or if the first channel coding mode is a Turbo code, channel decoding is performed on the to-be-sent sequence by using the Turbo code.

Optionally, after obtaining the sequence obtained after the channel decoding, the second communication apparatus may perform source decoding on the sequence obtained after the channel decoding, to obtain a data stream, where the data stream is consistent with the data stream generated by the source.

It can be learned that, in this embodiment of this application, a mapping relationship between a channel coding mode and a coding parameter, a device type, a service type, or the like is defined, and the channel coding mode selected by the receive end and the transmit end is notified based on indication information, so that an appropriate channel coding mode can be adaptively and flexibly selected, to meet a requirement of a diversified channel coding scenario and a corresponding performance indicator, and provide flexibility for a protocol and a system.

For step S101, the following separately describes in detail a manner of determining the first channel coding mode when the first parameter includes different elements.

### (1) The first parameter includes the coding parameter.

Specifically, the coding parameter includes one or more of a code length, an information bit length, a latency, or an error floor (error floor). The first communication apparatus determines the first channel coding mode based on the mapping relationship between a coding parameter and a channel coding mode and the coding parameter obtained by the first communication apparatus. The coding parameter obtained by the first communication apparatus includes a code length determined by the first communication apparatus, an information bit length of the to-be-sent sequence, or a requirement of the first communication apparatus for the error floor or a size of the latency.

The to-be-sent sequence in this embodiment of this application is the sequence obtained after performing channel coding on the data stream generated by the source. The first communication apparatus may calculate a code length of the to-be-sent sequence based on the information bit length of the to-be-sent sequence and a preset algorithm. In a channel coding process, the first communication apparatus codes the to-be-sent sequence as the code length calculated by the first communication apparatus. For example, if the information bit length of the to-be-sent sequence is 256 bits, and a code rate requires to be 1/2, the code length is 128 bits. In other words, the first communication apparatus needs to code the 256-bit to-be-sent sequence into 128 bits in the channel coding process.

The mapping relationship between a coding parameter and a channel coding mode may be standard-defined. Optionally, the mapping relationship between a coding parameter and a channel coding mode includes at least one of the following cases: when a value of the coding parameter is less than or equal to a first coding parameter threshold, the channel coding mode is a first coding mode; when a value of the coding parameter is greater than the first coding parameter threshold and less than a second coding parameter threshold, the channel coding mode is a second coding mode; or when a value of the coding parameter is greater than or equal to the second coding parameter threshold, the channel coding mode is a third coding mode. It should be understood that the value of the coding parameter may alternatively be compared with only one threshold. For example, when the value of the coding parameter is less than or equal to a specific threshold, the channel coding mode is a coding mode 1; or when the value of the coding parameter is greater than a specific threshold, the channel coding mode is a coding mode 2. A quantity of thresholds is not limited in this embodiment of this application.

In an example, when the coding parameter is the code length, the mapping relationship between a code length and a channel coding mode may be shown in the following Table 1. When the code length is less than or equal to the first code length threshold (namely, Nₜₕ₁), the channel coding mode (for example, the first coding mode) is any one of a Reed-Muller code (Reed-Muller code, RM code for short), a BCH code (BCH code, Bose-Chaudhuri-Hocquenghem code), or a Reed-Solomon code (Reed-Solomon code, RS code for short). When the code length is greater than the first code length threshold (namely, Nₜₕ₁) and less than the second code length threshold (namely, Nₜₕ₂), the channel coding mode (for example, the second coding mode) is a Polar code (Polar code) or a Turbo product code (Turbo product code, TPC)-Polar code (TPC-Polar code). When the code length is greater than or equal to the second code length threshold (namely, Nₜₕ₂), the channel coding mode (for example, the third coding mode) is any one of a low-density parity-check code (Low-density parity-check code, LDPC code), a coupled LDPC code, or a coupled Polar code. It should be understood that when the code length is equal to the first code length threshold (namely, Nₜₕ₁), the channel coding mode may alternatively be a Polar code or a TPC-Polar code. Similarly, when the code length is equal to the second code length threshold (namely, Nₜₕ₂), the channel coding mode may alternatively be a Polar code or a TPC-Polar code. It should be understood that a number of the code length in Table 1 may not exist during actual application, and the number of the code length indicates a sequence number. Optionally, the mapping relationship between a code length and a channel coding mode may alternatively be as follows: When the code length is less than or equal to a code length threshold A, the channel coding mode is any one of an RM code, a BCH code, or an RS code; or when the code length is greater than a code length threshold A, the channel coding mode is any one of a Polar code, a TPC-Polar code, an LDPC code, a coupled LDPC code, or a coupled Polar code.

**Table 1**

| **Number of the code length** | **Interval of the code length** | **Channel coding mode** |
|---|---|---|
| CL 1 | Code length ≤ Nₜₕ₁ | Code 1: RM code, BCH code, or RS code |
| CL 2 | Nₜₕ₁ < code length < Nₜₕ₂ | Code 2: Polar code or TPC-Polar code |
| CL 3 | Code length ≥ Nₜₕ₂ | Code 3: LDPC code, coupled LDPC code, or coupled Polar code |

It may be understood that the RM code, the BCH code, or the RS code belongs to a short code (where the short code generally means that a quantity of codeword bits is small, for example, a code whose code length is 64 bits is usually considered as a short code), and has excellent performance in a short code area, but has a low coding gain and high complexity in a long code area. Therefore, when the code length is short, channel coding is performed by using the short code, so that performance is excellent and complexity is low. The Polar code has excellent performance under all code lengths and rates. The TPC-Polar code uses the Polar code as a mother code, and is obtained through customization for a specific scenario by using a feature that the Polar code maintains superior performance in a wide range of code lengths and rates. For example, for a low-complexity decoder (for example, a successive cancellation decoding (Successive cancellation decoding, SC) decoder), decoding performance of the low-complexity decoder is good when complexity is low. In this case, a Polar code that meets a low-complexity requirement may be constructed by using the Polar code as the mother code and by using a construction method based on "Gaussian approximation". For a high-complexity decoder (for example, a successive cancellation list decoding (Successive cancellation list decoding, SCL) decoder), decoding performance of the high-complexity decoder is good. In this case, a Polar code that meets a high complexity requirement may be constructed by using the Polar code as the mother code, using a construction method based on a "polarization weight" or a "combination of a row weight and reliability", and using a parity-check outer code to improve code distance performance. For a high parallelism decoder (for example, a belief propagation decoding (Belief propagation decoding, BP) decoder), a higher parallelism degree of the high parallelism decoder indicates a higher throughput and better decoding performance. In this case, a Polar code that meets a high throughput may be constructed by using the Polar code as the mother code and by using a construction method based on a "G_{N}-coset code (G_{N}-coset code)". For a soft bit output decoder (for example, a BP decoder or a soft cancellation (soft cancellation, SCAN) decoder), if the decoder supports a soft bit output, some advanced large iterative algorithms may be performed at a receive end to improve decoding performance. Therefore, a Polar code that meets a requirement of the soft bit output decoder may be constructed by using the Polar code as the mother code and by using a construction method based on "a combination of a row weight and reliability". Therefore, when the code length is greater than Nₜₕ₁ and less than Nₜₕ₂, the Polar code or the TPC-Polar code that has excellent performance under all code lengths and rates is used. The LDPC code belongs to a long code (where the long code generally means that a quantity of codeword bits is large, for example, a code whose code length is 16384 bits is usually considered as a long code), and has low complexity and excellent performance in a long code area, but has insufficient performance in a short code area and a low code rate area. Therefore, when the code length is long, channel coding is performed by using the long code (for example, the LDPC code), the coupled LDPC code, or the coupled Polar code, so that performance is excellent.

Optionally, Nₜₕ₁ is less than Nₜₕ₂, and both values of Nₜₕ₁ and Nₜₕ₂ may be values in 8, 10, 12, 14, 16, 20, 24, 28, 32, 40, 48, 56, 64, 80, 96, 112, 128, 160, 192, 224, 256, 320, 384, 448, 512, 640, 768, 896, 1024, 1280, 1536, 1792, 2048, 2560, 3072, 3584, 4096, 5120, 6144, 7168, 8192, 10240, 12288, 14336, 16384, 20480, 24576, 28672, 32768, 40960, 49152, and 57344. It can be learned that the values of Nₜₕ₁ and Nₜₕ₂ are both an integer power of 2 or an integer power of 2 multiplied by 1.5. These values are easier to implement by hardware, and hardware storage is more convenient.

In an example, when the coding parameter is the information bit length, the mapping relationship between an information bit length and a channel coding mode may be shown in the following Table 2. When the information bit length is less than or equal to a first information bit length threshold (namely, Kₜₕ₁), the channel coding mode (or the first coding mode) is any one of an RM code, a BCH code, or an RS code. When the information bit length is greater than a first information bit length threshold (namely, Kₜₕ₁) and less than a second information bit length threshold (namely, Kₜₕ₂), the channel coding mode (or the second coding mode) is a Polar code or a TPC-Polar code. When the information bit length is greater than or equal to a second information bit length threshold (namely, Kₜₕ₂), the channel coding mode (or the third coding mode) is any one of an LDPC code, a coupled LDPC code, or a coupled Polar code. It should be understood that when the information bit length is equal to the first information bit length threshold (namely, Kₜₕ₁), the channel coding mode may alternatively be a Polar code or a TPC-Polar code. Similarly, when the information bit length is equal to the second information bit length threshold (namely, Kₜₕ₂), the channel coding mode may alternatively be a Polar code or a TPC-Polar code. It should be understood that a number of the information bit length in Table 2 may not exist during actual application, and the number of the information bit length indicates a sequence number. Optionally, the mapping relationship between an information bit length and a channel coding mode may alternatively be as follows: When the information bit length is less than or equal to an information bit length threshold A, the channel coding mode is any one of an RM code, a BCH code, or an RS code; or when the information bit length is greater than an information bit length threshold A, the channel coding mode is any one of a Polar code, a TPC-Polar code, an LDPC code, a coupled LDPC code, or a coupled Polar code.

**Table 2**

| **Number of the information bit length** | **Interval of the information bit length** | **Channel coding mode** |
|---|---|---|
| KL 1 | Information bit length ≤ Kₜₕ₁ | Code 1: RM code, BCH code, or RS code |
| KL 2 | Kₜₕ₁ < information bit length < Kₜₕ₂ | Code 2: Polar code or TPC-Polar code |
| KL 3 | Information bit length ≥ Kₜₕ₂ | Code 3: LDPC code, coupled LDPC code, or coupled Polar code |

It should be understood that, for a design of the mapping relationship between an information bit length and a channel coding mode, refer to the design of the mapping relationship between a code length and a channel coding mode. A principle of the mapping relationship is also similar to that of the mapping relationship between a code length and a channel coding mode. Details are not described herein again.

Optionally, Kₜₕ₁ is less than Kₜₕ₂, and both values of Kₜₕ₁ and Kₜₕ₂ may be values in 8, 10, 12, 14, 16, 20, 24, 28, 32, 40, 48, 56, 64, 80, 96, 112, 128, 160, 192, 224, 256, 320, 384, 448, 512, 640, 768, 896, 1024, 1280, 1536, 1792, 2048, 2560, 3072, 3584, 4096, 5120, 6144, 7168, 8192, 10240, 12288, 14336, 16384, 20480, 24576, 28672, 32768, 40960, 49152, and 57344. It can be learned that the values of Kₜₕ₁ and Kₜₕ₂ are both an integer power of 2 or an integer power of 2 multiplied by 1.5. These values are easier to implement by hardware, and hardware storage is more convenient.

In an example, when the coding parameter is the latency, the mapping relationship between a latency and a channel coding mode may be shown in the following Table 3. The latency herein may be an end-to-end latency or a decoding latency. When the latency is less than or equal to a first latency threshold (namely, Dₜₕ₁), the channel coding mode is an RM code or a BCH code. When the latency is greater than a first latency threshold (namely, Dₜₕ₁) and less than a second latency threshold (namely, Dₜₕ₁), the channel coding mode is a Polar code or an LDPC code. When the latency is greater than or equal to a second latency threshold (namely, Dₜₕ₂), the channel coding mode is a Turbo code (Turbo code, Turbo code for short) or a Polar code. It should be understood that, when the latency is equal to the first latency threshold (namely, Dₜₕ₁), the channel coding mode may alternatively be a Polar code or an LDPC code. Similarly, when the latency is equal to the second latency threshold (namely, Dₜₕ₁), the channel coding mode may alternatively be a Polar code or an LDPC code. It should be understood that a type of the latency in Table 3 may not exist during actual application. Optionally, the mapping relationship between a latency and a channel coding mode may alternatively be as follows: When the latency is less than or equal to a latency threshold A, the channel coding mode is any one of an RM code or a BCH code; or when the latency is greater than a latency threshold A, the channel coding mode is any one of a Polar code, an LDPC code, or a Turbo code.

**Table 3**

| **Type of the latency** | **Interval of the latency** | **Channel coding mode** |
|---|---|---|
| DL 1 | Ultra-short latency: latency ≤ Dₜₕ₁ | Code 1: RM code or BCH code |
| DL2 | Short latency: Dₜₕ₁ < latency < Dₜₕ₂ | Code 2: Polar code or LDPC code |
| DL 3 | Latency-insensitive: latency >_ Dₜₕ₂ | Code 3: Turbo code or Polar code |

It may be understood that, because the RM code and the BCH code belong to short codes, a decoding latency is short, and an end-to-end latency is also short. Therefore, when the first communication apparatus requires the ultra-short latency (where the latency < Dₜₕ₁), the RM code or the BCH code is used, so that a requirement of the first communication apparatus for the latency can be met, performance can be excellent in the short code area, and complexity is low. Polar codes all have excellent performance under all code lengths and rates, an LDPC code decoding algorithm is a parallel iterative decoding algorithm based on a sparse matrix, and an operation amount of the LDPC code decoding algorithm is lower than that of a Turbo code decoding algorithm. Therefore, when the first communication apparatus requires the short latency (where Dₜₕ₁ < the latency < Dₜₕ₂), the Polar code or the LDPC code is used, so that a requirement of the first communication apparatus for a size of the latency can be met, and coding/decoding performance is good. When the first communication apparatus does not have a high requirement for the latency and is insensitive to the latency, the Turbo code or the Polar code may be used, so that complexity is low and performance in the long code area is excellent.

Optionally, Dₜₕ₁ is less than Dₜₕ₂, and both values of Dₜₕ₁ and Dₜₕ₂ may be values in 1 µs, 10 µs, 100 µs, 1 ms, and 10 ms.

In an example, when the coding parameter is the error floor (error floor), the mapping relationship between an error floor and a channel coding mode may be shown in the following Table 4. It should be understood that the error floor may be used to reflect reliability. A smaller value of the error floor indicates higher reliability. When the error floor is less than or equal to a first error floor threshold (namely, Eₜₕ₁), the channel coding mode (or the first coding mode) is a Polar code or a BCH code. When the error floor is greater than a first error floor threshold (namely, Eₜₕ₁) and less than a second error floor threshold (namely, Eₜₕ₂), the channel coding mode (or the third coding mode) is an LDPC code. When the error floor is greater than or equal to a second error floor threshold (namely, Eₜₕ₂), the channel coding mode (or the third coding mode) is a Turbo code. It should be understood that, when the error floor is equal to the first error floor threshold (namely, Eₜₕ₁), the channel coding mode may alternatively be an LDPC code. Similarly, when the error floor is equal to the second error floor threshold (namely, Eₜₕ₂), the channel coding mode may alternatively be an LDPC code. It should be understood that a type of the reliability in Table 4 may not exist during actual application. Optionally, the mapping relationship between an error floor and a channel coding mode may alternatively be as follows: When the error floor is less than or equal to an error floor threshold A, the channel coding mode is any one of an RM code or a BCH code; or when the error floor is greater than an error floor threshold A, the channel coding mode is any one of a Polar code, an LDPC code, or a Turbo code.

**Table 4**

| **Type of the reliability** | **Interval of error floor (error floor)** | **Channel coding mode** |
|---|---|---|
| RL 1 | High reliability: error floor ≤ Eₜₕ₁ | Code 1: Polar code or BCH code |
| RL2 | Medium reliability: Eₜₕ₁ < error floor < Eₜₕ₂ | Code 2: LDPC code |
| RL 3 | Low reliability: error floor ≥ Eₜₕ₂ | Code 3: Turbo code |

It may be understood that, because the Polar code has no error floor, and the BCH code is a type of important error correction code and has a capability of correcting a plurality of random errors, an error floor of the BCH code is quite low. Therefore, when the first communication apparatus requires the high reliability (where the error floor ≤ Eₜₕ₁), the Polar code without an error floor or the BCH code with a quite low error floor is used, so that a requirement of the first communication apparatus for the error floor can be met. The LDPC code also has a low error floor (about 10⁻⁵), and may be applied to scenarios that have a strict requirement for a bit error rate, such as wired communication, deep space communication, and a disk storage industry. The error floor of the Turbo code is above an order of magnitude of 10⁻³. Therefore, when the first communication apparatus requires the medium reliability (where Eₜₕ₁ < the error floor < Eₜₕ₂), the LDPC code is used; or when the first communication apparatus does not require the high reliability, that is, requires the low reliability (where the error floor ≥ Eₜₕ₂), the Turbo code is used, so that a corresponding channel coding mode is designed based on a requirement of the first communication apparatus.

Optionally, Eₜₕ₁ is less than Eₜₕ₂, and both values of Eₜₕ₁ and Eₜₕ₂ may be values in 10⁻¹, 10⁻², 10⁻³, 10⁻¹, 10⁻⁵, 10⁻⁶, 10⁻⁷, 10⁻⁸, and 10⁻⁹. It should be understood that the values of Eₜₕ₁ and Eₜₕ₂ may be specified based on a service requirement. For example, if a service requires the high reliability, the values of Eₜₕ₁ and Eₜₕ₂ may be 10⁻⁵, 10⁻⁶, or the like. If a service requires the low reliability, the values of Eₜₕ₁ and Eₜₕ₂ may be 10⁻¹, 10⁻², or the like.

Optionally, after determining the first channel coding mode, the first communication apparatus may send the first message to the second communication apparatus, where the first message indicates the first channel coding mode.

For example, the first message is DCI. When the first parameter includes the coding parameter, two bits may be used to indicate the first channel coding mode. Specifically, for a DCI indication manner, refer to the following Table 5. A code type (code type) field in the DCI indicates the first channel coding mode, and a length of the code type (code type) field is two bits. For example, when a value of the two bits is 00, it indicates the third column and the second row in any one of Table 1 to Table 4; when a value of the two bits is 01, it indicates the third column and the third row in any one of Table 1 to Table 4; when a value of the two bits is 10, it indicates the third column and the fourth row in any one of Table 1 to Table 4; or when a value of the two bits is 11, it indicates to be reserved. Alternatively, when a value of the two bits is 00, it indicates to be reserved; when a value of the two bits is 01, it indicates the third column and the second row in any one of Table 1 to Table 4; when a value of the two bits is 10, it indicates the third column and the third row in any one of Table 1 to Table 4; or when a value of the two bits is 11, it indicates the third column and the fourth row in any one of Table 1 to Table 4. A correspondence between the value and the reference of the two bits is not limited in this embodiment of this application.

**Table 5**

| DCI indication | | |
|---|---|---|
| **Field Field** | **Quantity of bits Bits** | **Reference Ref.** |
| Code type Code Type | 2 | Refer to descriptions of any one of Table 1 to Table 4 |

### (2) The first parameter includes the service type.

In this embodiment of this application, service categories are classified based on different application scenarios. For example, a service in an eMBB scenario is referred to as an eMBB service, a service in an URLLC scenario is referred to as an URLLC service, a service in a massive machine type communication (massive Machine Type Communication, mMTC) scenario is referred to as an mMTC service, a service in an ultra high throughput (ultra high throughput, uHTP) scenario is referred to as an ultra high throughput service, a service in an autonomous driving scenario is referred to as an autonomous driving service, or a service in an industrial network scenario is referred to as an industrial network service.

Specifically, the first communication apparatus determines the first channel coding mode based on the mapping relationship between a service type and a channel coding mode and a service type to which the to-be-sent sequence belongs. The mapping relationship between a service type and a channel coding mode may be standard-defined.

In an example, the mapping relationship between a service type and a channel coding mode may be shown in the following Table 6. When the service type is the eMBB service, the channel coding mode is an LDPC code or a Polar code. When the service type is the URLLC service, the channel coding mode is a BCH-Polar code or a Golay code (Golay code). When the service type is the mMTC service, the channel coding mode is any one of a tail-biting convolutional code (Tail-biting convolutional code, TBCC code for short), a Polar code, or a BCH code. When the service type is the ultra high throughput service, the channel coding mode is any one of a TPC-Polar code, a G_{N}-coset code, or an LDPC code. When the service type is the autonomous driving service, the channel coding mode is a BCH-Polar code. When the service type is the industrial network service, the channel coding mode is any one of an RM code, a BCH code, or an RS code. It should be understood that a number of the service type in Table 6 may identify the service type, and may not exist during actual application.

**Table 6**

| **Number of the service type** | **Service type** | **Channel coding mode** |
|---|---|---|
| AS 1 | eMBB service | Code 1: Polar code or LDPC code |
| AS 2 | URLLC service | Code 2: BCH-Polar code or Golay code |
| AS 3 | mMTC service | Code 3: TBCC code, Polar code, or BCH code |
| AS 4 | High throughput service | Code 4: TPC-Polar code, G_{N}-coset code, or LDPC code |
| AS 5 | Autonomous driving service | Code 5: BCH-Polar code |
| AS 6 | Industrial network service | Code 6: RM code, BCH code, or RS code |

It may be understood that eMBB refers to further improvement of performance such as user experience based on an existing mobile broadband service scenario. The eMBB service has a requirement for large traffic and large bandwidth, but the eMBB service does not have a high requirement for reliability. Polar codes all have excellent performance under all code lengths and rates. An LDPC code decoding algorithm is a parallel iterative decoding algorithm based on a sparse matrix, and a parallelism degree is higher than that of a Turbo code decoding algorithm. A high throughput is easily implemented in hardware. Therefore, in large-capacity communication applications, the LDPC code has more advantages. Therefore, when the service type to which the to-be-sent sequence belongs is the eMBB service, the Polar code or the LDPC code is used, so that a requirement of the eMBB service for large bandwidth can be met.

URLLC mainly reflects a requirement of communication between objects, has features such as high reliability or a low latency, and may be applied to a scenario such as industrial control, factory automation, a smart grid, a device, internet of vehicles communication, or a remote surgery. The BCH-Polar code uses a Polar code as a mother code, and is obtained through customization for a specific scenario by using a feature that the Polar code maintains superior performance in a wide range of code lengths and rates. The BCH-Polar code combines advantages of the Polar code and the BCH code, that is, reserves the advantage that the Polar code maintains superior performance in a wide range of code lengths and rates, and has the advantage that the BCH code belongs to a short code (a low latency). The Golay code is a fixed code that can correct three random error codes, where a code length is 23 and an information element is 12. Because the code length of the Golay code is short, a latency of the Golay code is low; and because the Golay code can correct the random error codes, reliability of the Golay code is high. Therefore, when the service type to which the to-be-sent sequence belongs is the URLLC service, the BCH-Polar code or the Golay code is used, so that a requirement of the URLLC service for high reliability and a low latency can be met.

mMTC mainly reflects information exchange between humans and things, and has features such as a small data packet, low power consumption, and massive connections. Therefore, the mMTC service is featured by low power consumption, a large quantity of connections, or the like. Both the TBCC code and the BCH code belong to short codes, and have excellent performance in a short code area. Because a code length is short, coding/decoding power consumption of the TBCC code is low. The Polar code has excellent performance under all code lengths and rates. Therefore, when the service type to which the to-be-sent sequence belongs is the mMTC service, the TBCC code, the BCH code, or the Polar code is used, so that a requirement of the mMTC service for low power consumption can be met.

The ultra high throughput service requires an ultra high throughput. The TPC-Polar code uses a Polar code as a mother code, and uses a feature that the Polar code maintains superior performance in a wide range of code lengths and rates. The TPC-Polar code combines advantages of the Polar code and the TPC code, that is, reserves the advantage that the Polar code maintains superior performance in a wide range of code lengths and rates, and has the advantage of the TPC code (decoding performance close to a Shannon limit and a parallel structure suitable for highspeed decoding). The G_{N}-coset code is a type of generalized Polar code. A construction (information bit selection) method of the G_{N}-coset code is different from that of the Polar code, and is designed for iterative decoding optimization with high parallelism. A decoding algorithm of the G_{N}-coset code performs parallel decoding only on an inner code, iteratively exchanges the inner code and an outer code, and exchanges soft information of the inner code and the outer code. The LDPC code has excellent performance close to the Shannon limit, and is featured by low decoding complexity, parallel decoding, and detectability of decoding errors. Therefore, when the service type to which the to-be-sent sequence belongs is the ultra high throughput service, the TPC-Polar code, the LDPC code, or the G_{N}-coset code is used, so that a requirement of the ultra high throughput service for a throughput can be met.

The autonomous driving service may be considered as a small type of service in the URLLC service, and is also featured by high reliability, a low latency, and a large capacity. Therefore, when the service type to which the to-be-sent sequence belongs is the autonomous driving service, the BCH-Polar code is used, so that a requirement of the autonomous driving service for high reliability, a low latency, and a large capacity can be met.

The industrial network is a fully digital, bidirectional, and multi-station communication system installed in an industrial production environment, and transmits a short length of data. The RM code, the BCH code, or the RS code belongs to a short code, and has excellent performance in a short code area, but has an insufficient coding gain and high complexity in a long code area. Therefore, when the service type to which the to-be-sent sequence belongs is the industrial network service, channel coding is performed by using the short code, so that performance is excellent and complexity is low.

Optionally, after determining the first channel coding mode, the first communication apparatus may send the first message to the second communication apparatus, where the first message indicates the first channel coding mode. The first message may be a matching indication of an RRC message and DCI, that is, the RRC message and the DCI jointly indicate the first channel coding mode. Specifically, an RRC message is newly added to define a correspondence between a value of a code type (code type) field in the DCI and the service type. For example, the newly added RRC message is ServiceConfig :: = Sequence {ServiceType ENUMERATED {eMBB, URLLC, mMTC, uHTP, AutoV, IN}}. An English full name of the English abbreviation "AutoV" herein is "Autonomous vehicles", and represents the autonomous driving service. An English full name of the English abbreviation "IN" is "Industrial networks", and represents the industrial network service. It should be understood that English abbreviations of the autonomous driving service and the industrial network service in the RRC message are not limited in this embodiment of this application.

For a DCI indication manner, refer to the following Table 7. For example, when the value of the code type field defined in the RRC message is 000, it indicates the eMBB service. When the value of the code type field defined in the RRC message is 001, it indicates the URLLC service. When the value of the code type field defined in the RRC message is 010, it indicates the mMTC service. When the value of the code type field defined in the RRC message is 011, it indicates the ultra high throughput service. When the value of the code type field defined in the RRC message is 100, it indicates the autonomous driving service. When the value of the code type field defined in the RRC message is 101, it indicates the industrial network service. When the value of the code type field defined in the RRC message is 110 or 111, it indicates to be reserved. It should be understood that there may be another correspondence between the value of the code type field and the service type. This is not limited in this embodiment of this application.

**Table 7**

| DCI indication | | |
|---|---|---|
| **Field Field** | **Quantity of bits Bits** | **Reference Ref.** |
| Code type Code Type | 3 | Refer to Table 6 and the correspondence between the value of the code type field in the RRC message and the service type |

### (3) The first parameter includes the device type.

In this embodiment of this application, a device number is assigned to each access device, and the device number identify a device type. The device types mentioned in this embodiment of this application may include an active device, a passive device, a low power consumption device, a high throughput device, a high-reliable device, and a low-latency device. The active device may be a device that has a power supply and can actively send a signal. The passive device may be a device that has no power supply, passively receives a signal, cannot actively send a signal, and can only reflect a signal.

Specifically, before step S101, the second communication apparatus may send a second message to the first communication apparatus, where the second message indicates a device type of the second communication apparatus. The device type of the second communication apparatus may be pre-specified. For example, the device type of the second communication apparatus is preset in an internal/system program of the device before delivery of a manufacturer. The second message may be UCI. It should be understood that the device type of the second communication apparatus may alternatively be considered as a decoding capability (Decoding Capability) of the second communication apparatus. For example, three bits in the UCI may indicate the device type (or the decoding capability) of the second communication apparatus. For a specific indication manner, refer to the following Table 8. When a value of the three bits is a first value, it indicates the active device. When a value of the three bits is a second value, it indicates the passive device. When a value of the three bits is a third value, it indicates the low power consumption device. When a value of the three bits is a fourth value, it indicates the high throughput device. When a value of the three bits is a fifth value, it indicates the high-reliable device. When a value of the three bits is a sixth value, it indicates the low-latency device. When a value of the three bits is a seventh value and an eighth value, it indicates to be reserved. The first value to the eighth value may be 0, 1, 2, 3, 4, 5, 6, and 7 respectively.

**Table 8**

| UCI indication | | |
|---|---|---|
| **Field Field** | **Value** | **Reference** |
| Decoding capability (Decoding Capability)/device type (device type) | First value | Active device |
| | Second value | Passive device |
| | Third value | Low power consumption device |
| | Fourth value | High throughput device |
| | Fifth value | High-reliable device |
| | Sixth value | Low-latency device |
| | Seventh value | Reserved |
| | Eighth value | Reserved |

After receiving the second message, the first communication apparatus determines, based on the mapping relationship between a device type and a channel coding mode, the first channel coding mode corresponding to the device type (or the decoding capability) of the second communication apparatus. In other words, a terminal reports the decoding capability (Decoding Capability) by using the UCI, and a base station selects an optimal channel coding scheme and a coding parameter based on the decoding capability, and indicates channel coding selection by using the DCI. The mapping relationship between a device type (or the decoding capability) and a channel coding mode may be standard-defined.

In an example, the mapping relationship between a device type and a channel coding mode may be shown in the following Table 9. When the device type is the active device, the channel coding mode is an LDPC code or a Polar code. When the device type is the passive device, the channel coding mode is a short sequence or a short cyclic code. When the device type is the low power consumption device, the channel coding mode is any one of a TBCC, a Polar code, or a BCH code. When the device type is the high throughput device, the channel coding mode is any one of a TPC-Polar code, a G_{N}-coset code, or an LDPC code. When the device type is the high-reliable device, the channel coding mode is any one of a Polar code, a BCH code, or an RS code. When the device type is the low-latency device, the channel coding mode is any one of a Polar code, a BCH code, an RS code, or an LDPC code.

**Table 9**

| **Device number** | **Device type** | **Channel coding mode** |
|---|---|---|
| DT 1 | Active device | Code 1: Polar code or LDPC code |
| DT 2 | Passive device | Code 2: short sequence (Grey-coded sequence), short cyclic code (for example, a BCH code) |
| DT 3 | Low power consumption device | Code 3: TBCC code, Polar code, or BCH code |
| DT 4 | High throughput device | Code 4: TPC-Polar code, G_{N}-coset code, or LDPC code |
| DT 5 | High-reliable device | Code 5: Polar code, BCH code, or RS code |
| DT 6 | Low-latency device | Code 6: Polar code, BCH code, RS code, or LDPC code |

It may be understood that the active device is a device that has a power supply, may actively transmit a radio signal, and may support a channel coding mode with high complexity and a long code length. The LDPC code has low complexity and excellent performance in a long code area, but has insufficient performance in a short code area and a low code rate area. Therefore, when the device type of the second communication apparatus is the active device, the Polar code or the LDPC code is used, so that a requirement of the active device is met and performance is excellent. The passive device is a device that has no power supply, passively receives a signal, collects radio signal energy in an environmental signal, modulates the radio signal energy, and then reflects the radio signal energy to another device. Therefore, the passive device can support only a channel coding mode with a short code length, low complexity, and low power consumption, to reduce coding/decoding energy consumption of the passive device. Therefore, when the device type of the second communication apparatus is the passive device, the short sequence or the short cyclic code is used, so that a requirement of the passive device is met. Because the low power consumption device requires low power consumption, the TBCC code, the BCH code, or the Polar code may be used, so that a requirement of the low power consumption device for power consumption can be met. Because the high throughput device requires a high throughput, the TPC-Polar code, the LDPC code, or the G_{N}-coset code may be used, so that a requirement of the high throughput device for a throughput can be met. The high-reliable device requires high reliability. Reliability can be reflected by an error floor. A smaller error floor indicates higher reliability. The Polar code has no error floor. The BCH code is a type of important error correction code, and has a capability of correcting a plurality of random errors. That is, an error floor of the BCH code is quite low. The RS code is a type of special nonbinary BCH code with a strong error correction capability. Therefore, an error floor of the RS code is also quite low. Therefore, when the device type of the second communication apparatus is the high-reliable device, the Polar code, the BCH code, or the RS code is used, so that a requirement of the high-reliable device for reliability can be met. Because the low-latency device requires a low latency, the Polar code, the BCH code, the RS code, or the LDPC code may be used, so that a requirement of the low-latency device for a latency can be met.

It may be further understood that the active device, the passive device, the low power consumption device, the high throughput device, the high-reliable device, and the low-latency device may be in a non-strict parallel relationship. For example, the active device and the passive device are considered as two main categories. The active device may include sub-categories such as the low power consumption device, the high throughput device, the high-reliable device, and the low-latency device. In this case, the channel coding mode may be selected based on the sub-category, or an intersection set of channel coding modes corresponding to the main category and the sub-category may be used. It is assumed that the second communication apparatus is both the active device and the low power consumption device. In this case, the channel coding mode, namely, the TBCC code, the BCH code, or the Polar code, corresponding to the low power consumption device is used. It is assumed that the second communication apparatus is both the active device and the high-reliable device. In this case, an intersection set between the channel coding mode (the Polar code or the LDPC code) corresponding to the active device and the channel coding mode (the Polar code, the BCH code, or the RS code) corresponding to the high-reliable device, namely, the Polar code, is used.

Optionally, after determining the first channel coding mode, the first communication apparatus may send the first message to the second communication apparatus, where the first message indicates the first channel coding mode. For example, the first message is DCI. When the first parameter includes the device type, three bits may be used to indicate the first channel coding mode. Specifically, for a DCI indication manner, refer to the following Table 10. A code type (code type) field in the DCI indicates the first channel coding mode, and a length of the code type (code type) field is three bits. For example, when a value of the three bits is a first value, it indicates the third column and the second row in Table 9; when a value of the three bits is a second value, it indicates the third column and the third row; when a value of the three bits is a third value, it indicates the third column and the fourth row; when a value of the three bits is a fourth value, it indicates the third column and the fifth row; when a value of the three bits is a fifth value, it indicates the third column and the sixth row; or when a value of the three bits is a sixth value, it indicates the third column and the seventh row. When a value of the three bits is a seventh value and an eighth value, it indicates to be reserved. The first value to the eighth value may be 0, 1, 2, 3, 4, 5, 6, and 7 respectively. A correspondence between the value and the reference of the three bits is not limited in this embodiment of this application.

**Table 10**

| DCI indication | | |
|---|---|---|
| **Field Field** | **Quantity of bits Bits** | **Reference Ref.** |
| Code type Code Type | 3 | Refer to descriptions in Table 9 |

### (4) The first parameter includes the coding feature.

Specifically, before step S101, the second communication apparatus may send a third message to the first communication apparatus, where the third message indicates a coding feature supported by the second communication apparatus. The coding feature includes one or more of a hybrid automatic repeat request (hybrid automatic repeat request, HARQ), an outer erasure code (Outer Erasure Code), or network coding (Network coding). In other words, a terminal reports supported coding features (Channel Coding Features) by using UCI, for example, whether the HARQ is supported, whether the outer erasure code is supported, or whether the network coding is supported, and a base station selects the channel coding mode and the coding parameter based on the channel coding features. For example, channel coding selection is introduced in a random access channel (Random Access Channel, RACH) interaction process.

The second message may be UCI. For example, three bits may be used in the UCI to indicate the coding feature supported by the second communication apparatus. To be specific, one bit indicates whether the second communication apparatus supports the HARQ, one bit indicates whether the second communication apparatus supports the outer erasure code, and the other bit indicates whether the second communication apparatus supports the network coding. For a specific indication manner, refer to the following Table 11. When a value of a field (one bit) for supporting the HARQ is 0, it indicates that the HARQ is not supported. When a value of a field (one bit) for supporting the HARQ is 1, it indicates that the HARQ is supported. When a value of a field (one bit) for supporting the outer erasure code is 0, it indicates that the outer erasure code is not supported. When a value of a field (one bit) for supporting the outer erasure code is 1, it indicates that the outer erasure code is supported. When a value of a field (one bit) for supporting the network coding is 0, it indicates that the network coding is not supported. When a value of a field (one bit) for supporting the network coding is 1, it indicates that the network coding is supported. It should be understood that 0 may alternatively indicate supporting, and 1 may indicate not supporting.

**Table 11**

| UCI indication | | |
|---|---|---|
| **Field Field** | **Value** | **Reference** |
| Support the HARQ (HARQ support) | 0 | Not support (No) |
| | 1 | Support (Yes) |
| Support the outer erasure code (Outer Erasure Code support) | 0 | Not support (No) |
| | 1 | Support (Yes) |
| Support the network coding (Network coding support) | 0 | Not support (No) |
| | 1 | Support (Yes) |

After receiving the third message, the first communication apparatus generates, based on the coding feature supported by the second communication apparatus and by using any code (for example, a Polar code, an LDPC code, an RM code, a BCH code, an RS code, a Tubor code, or a TBCC code) as a mother code, the first channel coding mode that meets the coding feature. For example, if the second communication apparatus supports the HARQ, does not support the outer erasure code, and supports the network coding, the first communication apparatus generates, by using the Polar code as the mother code, the first channel coding mode that meets three conditions: supporting the HARQ, not supporting the outer erasure code, and supporting the network coding.

Optionally, after determining the first channel coding mode, the first communication apparatus may send the first message to the second communication apparatus, where the first message indicates the first channel coding mode.

It should be understood that the network coding is an information exchange technology that integrates routing and coding. A core idea of the network coding is to perform linear or non-linear processing on information received on each channel on each node in a network, and then forward the information to a downstream node. An intermediate node plays a role of an encoder or a signal processor. The network coding allows a network node to participate in data processing on a basis of conventional data forwarding, and has become an effective method to improve a network throughput, robustness, and security.

(5) The first parameter includes the modulation and coding scheme (Modulation and Coding Scheme, MCS) or the transport block size (Transport Block Size, TBS).

Specifically, the first communication apparatus obtains the MCS or the TBS of this communication, and determines the first channel coding mode based on the mapping relationship between an MCS index or a TBS index and a channel coding mode and the obtained MCS or TBS of this communication. In other words, the channel coding mode is bound with another configuration index (namely, the MCS/TBS), and a base station selects the channel coding by indicating a flag bit (namely, the MCS/TBS). The mapping relationship between an MCS index or a TBS index and a channel coding mode may be standard-defined.

In an example, the mapping relationship between an MCS index and a channel coding mode may be shown in Table 12, and the mapping relationship between a TBS index and a channel coding mode may be shown in Table 13. When the MCS index is in a first interval (0 to M1), the channel coding mode is an RM code or a BCH code. When the MCS index is in a second interval (M1 to M2), the channel coding mode is a TBCC code. When the MCS index is in a third interval (M2 to M3), the channel coding mode is a Polar code. When the MCS index is in a fourth interval (M3 to M4), the channel coding mode is an LDPC code. When the MCS index is in a fifth interval (M4 to M5), the channel coding mode is a TPC-Polar code. When the TBS index is in a first interval (0 to T1), the channel coding mode is a Simplex (Simplex) code or an RM code. When the TBS index is in a second interval (T1 to T2), the channel coding mode is a BCH-Polar code. When the TBS index is in a third interval (T2 to T3), the channel coding mode is a Polar code. When the TBS index is in a fourth interval (T3 to T4), the channel coding mode is an LDPC code. When the TBS index is in a fifth interval (T4 to T5), the channel coding mode is a coupled Polar code. The first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval. The first interval, the second interval, the third interval, the fourth interval, and the fifth interval may be open intervals, or may be closed intervals, or may be left-open and right-closed intervals or left-closed and right-open intervals.

**Table 12**

| **MCS index/MCS index** | **Channel coding mode** |
|---|---|
| First interval (0 to M1) | Code 1: RM code or BCH code |
| Second interval (M1 to M2) | Code 2: TBCC code |
| Third interval (M2 to M3) | Code 3: Polar code |
| Fourth interval (M3 to M4) | Code 4: LDPC code |
| Fifth interval (M4 to M5) | Code 5: TPC-Polar code |

**Table 13**

| **TBS indexlTBS index** | **Channel coding mode** |
|---|---|
| First interval (0 to T1) | Code 1: Simplex code or RM code |
| Second interval (T1 to T2) | Code 2: BCH-Polar code |
| Third interval (T2 to T3) | Code 3: Polar code |
| Fourth interval (T3 to T4) | Code 4: LDPC code |
| Fifth interval (T4 to T5) | Code 5: coupled Polar code |

It may be understood that each MCS index corresponds to a physical transmission rate in a group of parameters. In a case of a same quantity of spatial streams, MCS indexes 0 to 7 indicate that transmission rates of the spatial streams are in ascending order. When the MCS index = 7, a value of a code rate is the largest. In a case of another quantity of spatial streams, MCS indexes 8 to 15 indicate that code rates of the spatial streams are also in ascending order. When the MCS index = 15, a value of a code rate is the largest. Therefore, the code lengths of the channel coding modes in Table 12 are also in ascending order. The TBS is a quantity of bits included in a transport block. The TBS indexes in ascending order indicate that quantities of bits included in one transport block are in ascending order. Therefore, the code lengths of the channel coding modes in Table 13 are also in ascending order.

Optionally, after determining the first channel coding mode, the first communication apparatus may send the first message to the second communication apparatus, where the first message indicates the first channel coding mode. The first message may be the MCS index or the TBS index.

The foregoing content describes in detail the method in this application. To better implement the foregoing solutions in embodiments of this application, embodiments of this application further provide a corresponding apparatus or device.

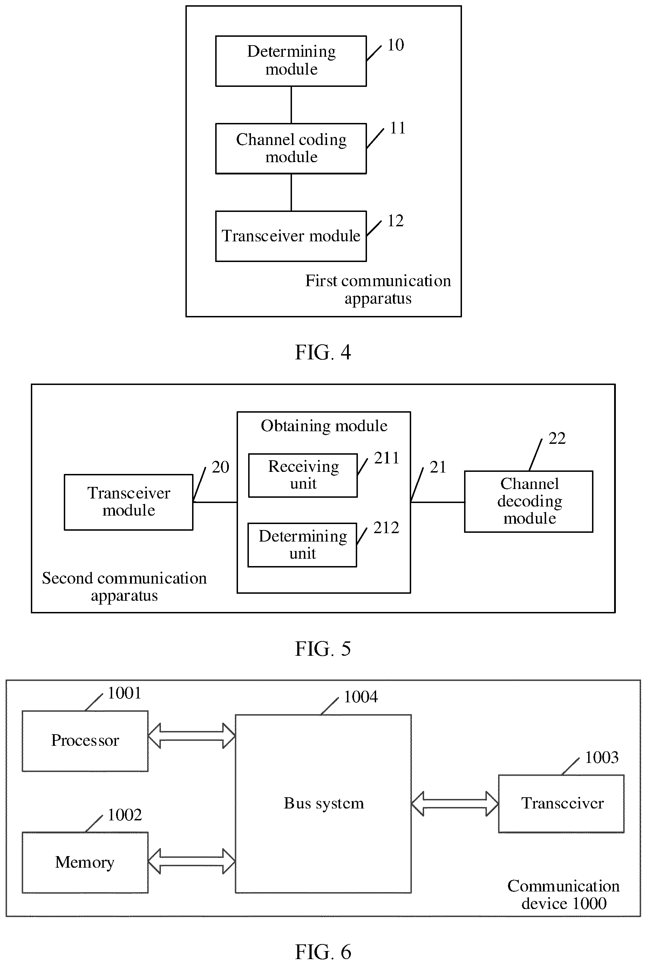

FIG. 4 is a schematic diagram of a structure of a first communication apparatus according to an embodiment of this application. The first communication apparatus may be a communication device, or may be a chip or a circuit disposed in the communication device. As shown in FIG. 4, the first communication apparatus may include:
a determining module 10, configured to determine a first channel coding mode based on a first parameter, where the first parameter includes one or more of a coding parameter, a service type, a device type, a coding feature, a modulation and coding scheme MCS, or a transport block size TBS; a channel coding module 11, configured to perform channel coding on a to-be-sent sequence by using the first channel coding mode, to obtain a coding sequence obtained after the channel coding; and a transceiver module 12, configured to send the coding sequence.

Optionally, the transceiver module 12 is further configured to send a first message, where the first message indicates the first channel coding mode. The first message may be a system broadcast message, a radio resource control message, downlink control information, uplink control information, sidelink control information, or the like.

Optionally, the first parameter includes the coding parameter, and the coding parameter includes one or more of a code length, an information bit length, a latency, or an error floor. The determining module 10 is specifically configured to determine the first channel coding mode based on a mapping relationship between a coding parameter and a channel coding mode and the coding parameter obtained by the first communication apparatus, where the coding parameter obtained by the first communication apparatus includes a code length determined by the first communication apparatus, an information bit length of the to-be-sent sequence, or a requirement of the first communication apparatus for the error floor or a size of the latency.

Optionally, the mapping relationship between a coding parameter and a channel coding mode includes at least one of the following cases: when a value of the coding parameter is less than or equal to a first coding parameter threshold, the channel coding mode is a first coding mode; when a value of the coding parameter is greater than the first coding parameter threshold and less than a second coding parameter threshold, the channel coding mode is a second coding mode; or when a value of the coding parameter is greater than or equal to the second coding parameter threshold, the channel coding mode is a third coding mode.

Optionally, if the coding parameter is the code length or the information bit length, the first coding mode is any one of a Reed-Muller RM code, a BCH code, or a Reed-Solomon RS code; the second coding mode is a Polar Polar code or a Turbo product code-Polar code TPC-Polar code; and the third coding mode is any one of a low-density parity-check code LDPC code, a coupled LDPC code, or a coupled Polar code.

Optionally, if the coding parameter is the latency, and the latency is an end-to-end latency or a decoding latency, the first coding mode is an RM code or a BCH code; the second coding mode is a Polar code or an LDPC code; and the third coding mode is a Turbo code Turbo code or a Polar code.

Optionally, if the coding parameter is the error floor, the first coding mode is a Polar code or a BCH code; the second coding mode is an LDPC code; and the third coding mode is a Turbo code.

Optionally, the first parameter includes the service type. The service type includes one or more of an eMBB service, an ultra-reliable low-latency communication URLLC service, a massive machine type communication mMTC service, an ultra high throughput service, an autonomous driving service, or an industrial network service. The determining module 10 is configured to determine the first channel coding mode based on a mapping relationship between a service type and a channel coding mode and a service type to which the to-be-sent sequence belongs.

Optionally, the mapping relationship between a service type and a channel coding mode includes at least one of the following cases: when the service type is the eMBB service, the channel coding mode is an LDPC code or a Polar code; when the service type is the URLLC service, the channel coding mode is a BCH-Polar code or a Golay code Golay code; when the service type is the mMTC service, the channel coding mode is any one of a tail-biting convolutional code TBCC, a Polar code, or a BCH code; when the service type is the ultra high throughput service, the channel coding mode is any one of a TPC-Polar code, a G_{N}-coset code, or an LDPC code; when the service type is the autonomous driving service, the channel coding mode is a BCH-Polar code; or when the service type is the industrial network service, the channel coding mode is any one of an RM code, a BCH code, or an RS code.

Optionally, the first parameter includes the device type. The transceiver module 12 is further configured to receive a second message, where the second message indicates a device type of a second communication apparatus; and the determining module 10 is specifically configured to determine, based on a mapping relationship between a device type and a channel coding mode, the first channel coding mode corresponding to a device type of the first communication apparatus.

Optionally, the mapping relationship between a device type and a channel coding mode includes at least one of the following cases: when the device type is an active device, the channel coding mode is an LDPC code or a Polar code; when the device type is a passive device, the channel coding mode is a short sequence or a short cyclic code; when the device type is a low power consumption device, the channel coding mode is any one of a TBCC, a Polar code, or a BCH code; when the device type is a high throughput device, the channel coding mode is any one of a TPC-Polar code, a G_{N}-coset code, or an LDPC code; when the device type is a high-reliable device, the channel coding mode is any one of a Polar code, a BCH code, or an RS code; or when the device type is a low-latency device, the channel coding mode is any one of a Polar code, a BCH code, an RS code, or an LDPC code.

Optionally, the first parameter includes the coding feature. The transceiver module 12 is further configured to receive a third message, where the third message indicates a coding feature supported by a second communication apparatus, and the coding feature includes one or more of a hybrid automatic repeat request HARQ, an outer erasure code, or network coding; and the determining module 10 is specifically configured to generate, based on the coding feature supported by the second communication apparatus, the first channel coding mode that meets the coding feature.

Optionally, the first parameter includes the MCS or the TBS. The determining module 10 is specifically configured to determine the first channel coding mode based on a mapping relationship between an MCS index or a TBS index and a channel coding mode and an MCS index or a transport block size index determined by the first communication apparatus.

Optionally, the first message is the MCS index or the TBS index. The mapping relationship between an MCS index or a TBS index and a channel coding mode includes at least one of the following cases: when the MCS index or the TBS index is in a first interval, the channel coding mode is any one of a Simplex Simplex code, an RM code, or a BCH code; when the MCS index or the TBS index is in a second interval, the channel coding mode is a TBCC or a BCH-Polar code; when the MCS index or the TBS index is in a third interval, the channel coding mode is a Polar code; when the MCS index or the TBS index is in a fourth interval, the channel coding mode is an LDPC code; or when the MCS index or the TBS index is in a fifth interval, the channel coding mode is a TPC-Polar code or a coupled Polar code, where

the first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval.

The determining module 10 and the channel coding module 11 may be integrated into one module, for example, a processing module.

During specific implementation, for implementation of the modules or units, refer to corresponding descriptions of the first communication apparatus in FIG. 3, and the modules or units perform the method and the functions performed by the first communication apparatus in FIG. 3.

FIG. 5 is a schematic diagram of a structure of a second communication apparatus according to an embodiment of this application. The second communication apparatus may be a communication device, or may be a chip or a circuit disposed in the communication device. As shown in FIG. 5, the second communication apparatus may include:
a transceiver module 20, further configured to receive a coding sequence; an obtaining module 21, configured to obtain a first channel coding mode, where the first channel coding mode is determined based on a first parameter, and the first parameter includes one or more of a coding parameter, a service type, a device type, a coding feature, a modulation and coding scheme MCS, or a transport block size TBS; and a channel decoding module 22, configured to perform channel decoding on the coding sequence by using the first channel coding mode, to obtain a sequence obtained after the channel decoding.

Optionally, the obtaining module 21 includes a receiving unit 211. The receiving unit 211 is configured to receive a first message, where the first message indicates the first channel coding scheme. The first message may be a system broadcast message, a radio resource control message, downlink control information, uplink control information, sidelink control information, or the like.

It may be understood that the obtaining module 21 may alternatively not include the receiving unit, and the obtaining module 21 may obtain the first channel coding mode from the first message received by the transceiver module 20. In other words, the transceiver module 20 is further configured to receive the first message, where the first message indicates the first channel coding mode; and the obtaining module 21 is specifically configured to obtain the first channel coding mode from the first message received by the transceiver module 20.

Optionally, the first parameter includes the coding parameter, and the coding parameter includes one or more of a code length, an information bit length, a latency, or an error floor. The obtaining module 21 includes a determining unit 212. The determining unit 212 is configured to determine the first channel coding mode based on a mapping relationship between a coding parameter and a channel coding mode and the coding parameter obtained by the second communication apparatus, where the coding parameter obtained by the second communication apparatus includes a code length of the coding sequence, an information bit length of a to-be-sent sequence, or a requirement of a first communication apparatus for the error floor or a size of the latency; and determine the first channel coding mode.

Optionally, the mapping relationship between a coding parameter and a channel coding mode includes at least one of the following cases: when a value of the coding parameter is less than or equal to a first coding parameter threshold, the channel coding mode is a first coding mode; when a value of the coding parameter is greater than the first coding parameter threshold and less than a second coding parameter threshold, the channel coding mode is a second coding mode; or when a value of the coding parameter is greater than or equal to the second coding parameter threshold, the channel coding mode is a third coding mode.

Optionally, if the coding parameter is the code length or the information bit length, the first coding mode is any one of a Reed-Muller RM code, a BCH code, or a Reed-Solomon RS code; the second coding mode is a Polar Polar code or a Turbo product code-Polar code TPC-Polar code; and the third coding mode is any one of a low-density parity-check code LDPC code, a coupled LDPC code, or a coupled Polar code.

Optionally, if the coding parameter is the latency, and the latency is an end-to-end latency or a decoding latency, the first coding mode is an RM code or a BCH code; the second coding mode is a Polar code or an LDPC code; and the third coding mode is a Turbo code Turbo code or a Polar code.

Optionally, if the coding parameter is the error floor, the first coding mode is a Polar code or a BCH code; the second coding mode is an LDPC code; and the third coding mode is a Turbo code.

Optionally, the first parameter includes the service type. The service type includes one or more of an eMBB service, an URLLC service, an mMTC service, an ultra high throughput service, an autonomous driving service, or an industrial network service. The obtaining module 21 includes a determining unit 212. The determining unit 212 is configured to determine the first channel coding mode based on a mapping relationship between a service type and a channel coding mode and a service type to which the coding sequence belongs.

Optionally, the mapping relationship between a service type and a channel coding mode includes at least one of the following cases: when the service type is the eMBB service, the channel coding mode is an LDPC code or a Polar code; when the service type is the URLLC service, the channel coding mode is a BCH-Polar code or a Golay code Golay code; when the service type is the mMTC service, the channel coding mode is any one of a tail-biting convolutional code TBCC, a Polar code, or a BCH code; when the service type is the ultra high throughput service, the channel coding mode is any one of a TPC-Polar code, a GN-coset code, or an LDPC code; when the service type is the autonomous driving service, the channel coding mode is a BCH-Polar code; or when the service type is the industrial network service, the channel coding mode is any one of an RM code, a BCH code, or an RS code.

Optionally, the first parameter includes the device type. The transceiver module 20 is further configured to send a second message, where the second message indicates a device type of the second communication apparatus. The obtaining module 21 includes a determining unit 212. The determining unit 212 is configured to determine, based on a mapping relationship between a device type and a channel coding mode, the first channel coding mode corresponding to a device type of the first communication apparatus.

Optionally, the mapping relationship between a device type and a channel coding mode includes at least one of the following cases: when the device type is an active device, the channel coding mode is an LDPC code or a Polar code; when the device type is a passive device, the channel coding mode is a short sequence or a short cyclic code; when the device type is a low power consumption device, the channel coding mode is any one of a TBCC, a Polar code, or a BCH code; when the device type is a high throughput device, the channel coding mode is any one of a TPC-Polar code, a G_{N}-coset code, or an LDPC code; when the device type is a high-reliable device, the channel coding mode is any one of a Polar code, a BCH code, or an RS code; or when the device type is a low-latency device, the channel coding mode is any one of a Polar code, a BCH code, an RS code, or an LDPC code.

Optionally, the first parameter includes the coding feature. The transceiver module 20 is further configured to send a third message, where the third message indicates a coding feature supported by the second communication apparatus, and the coding feature includes one or more of a HARQ, an outer erasure code, or network coding. The obtaining module 21 includes a determining unit 212. The determining unit 212 is configured to generate, based on the coding feature supported by the second communication apparatus, the first channel coding mode that meets the coding feature.

Optionally, the first parameter includes the MCS or the TBS. The obtaining module 21 includes a determining unit 212. The determining unit 212 is configured to determine the first channel coding mode based on a mapping relationship between an MCS index or a TBS index and a channel coding mode and an MCS or a transport block size indicated by a first communication apparatus.

Optionally, the first message is the MCS index or the TBS index. The mapping relationship between an MCS index or a TBS index and a channel coding mode includes at least one of the following cases: when the MCS index or the TBS index is in a first interval, the channel coding mode is any one of a Simplex Simplex code, an RM code, or a BCH code; when the MCS index or the TBS index is in a second interval, the channel coding mode is a TBCC or a BCH-Polar code; when the MCS index or the TBS index is in a third interval, the channel coding mode is a Polar code; when the MCS index or the TBS index is in a fourth interval, the channel coding mode is an LDPC code; or when the MCS index or the TBS index is in a fifth interval, the channel coding mode is a TPC-Polar code or a coupled Polar code, where

the first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval.

The obtaining module 21 and the channel decoding module 22 may be integrated into one module, for example, a processing module.

During specific implementation, for implementation of the modules or units, refer to corresponding descriptions of the second communication apparatus in FIG. 3, and the modules or units perform the method and the functions performed by the second communication apparatus in FIG. 3.

FIG. 6 is a schematic diagram of a structure of a communication device according to an embodiment of this application. As shown in FIG. 6, the communication device 1000 provided in this embodiment of this application includes a processor 1001, a memory 1002, a transceiver 1003, and a bus system 1004. The communication device provided in this embodiment of this application may be either of the first communication apparatus and the second communication apparatus.

The processor 1001, the memory 1002, and the transceiver 1003 are connected through the bus system 1004.

The memory 1002 is configured to store a program. Specifically, the program may include program code, and the program code includes computer operation instructions. The memory 1002 includes but is not limited to a random access memory (random access memory, RAM), a read-only memory (read-only memory, ROM), an erasable programmable read-only memory (erasable programmable read-only memory, EPROM), or a compact disc read-only memory (compact disc read-only memory, CD-ROM). Only one memory is shown in FIG. 6. Certainly, a plurality of memories may be disposed as required. The memory 1002 may alternatively be a memory in the processor 1001. This is not limited herein.

The memory 1002 stores the following elements, executable units or data structures, or subsets or extended sets thereof:
operation instructions, including various operation instructions and used to implement various operations; and
an operating system, including various system programs and configured to implement various basic services and process a hardware-based task.

The processor 1001 controls an operation of the communication apparatus 1000. The processor 1001 may be one or more central processing units (central processing units, CPUs). When the processor 1001 is one CPU, the CPU may be a single-core CPU, or may be a multi-core CPU.

During specific application, various components of the communication device 1000 are coupled together through the bus system 1004. In addition to a data bus, the bus system 1004 may further include a power bus, a control bus, a status signal bus, and the like. However, for clear description, various buses are marked as the bus system 1004 in FIG. 6. For ease of illustration, FIG. 6 merely shows an example of the communication device 1000.

The method of the first communication apparatus provided in the foregoing embodiment or the method of the second communication apparatus provided in the foregoing embodiment may be applied to the processor 1001, or may be implemented by the processor 1001. The processor 1001 may be an integrated circuit chip and has a signal processing capability. In an implementation process, each step in the foregoing method may be completed through an integrated logic circuit of hardware in the processor 1001 or instructions in a form of software. The foregoing processor 1001 may be a general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, or a discrete hardware component. It may implement or perform the methods, the steps, and logical block diagrams that are disclosed in embodiments of this application. The general-purpose processor may be a microprocessor, or the processor may be any conventional processor or the like. Steps of the methods disclosed with reference to embodiments of this application may be directly executed and accomplished by a hardware decoding processor, or may be executed and accomplished through a combination of hardware and software modules in the decoding processor. A software module may be located in a mature storage medium in the art, such as a random access memory, a flash memory, a read-only memory, a programmable read-only memory, an electrically erasable programmable memory, or a register. The storage medium is located in the memory 1002. The processor 1001 reads information in the memory 1002, and performs, in combination with hardware of the processor 1001, the method steps of the first communication apparatus described in the foregoing embodiments, or performs, in combination with hardware of the processor 1001, the method steps of the second communication apparatus described in the foregoing embodiments.

An embodiment of this application further provides a computer program product. The computer program product includes computer program code. When the computer program code is run on a computer, the computer is enabled to perform the method steps of the first communication apparatus described in the foregoing embodiments. Alternatively, when the computer program code is run on a computer, the computer is enabled to perform the method steps of the second communication apparatus described in the foregoing embodiments.

An embodiment of this application further provides a computer-readable storage medium. The computer-readable storage medium stores program instructions. When the program instructions are run on a computer, the computer is enabled to perform the method steps of the first communication apparatus described in the foregoing embodiments. Alternatively, when the computer program code is run on a computer, the computer is enabled to perform the method steps of the second communication apparatus described in the foregoing embodiments.

An embodiment of this application further provides an apparatus. The apparatus may be a chip. The chip includes a processor. The processor is configured to read and execute a computer program stored in a memory, to perform the channel coding method in any possible implementation of the foregoing embodiments. Optionally, the chip further includes the memory, and the memory is connected to the processor through a circuit or a wire. Further, optionally, the chip includes a communication interface, and the processor is connected to the communication interface. The communication interface is configured to receive data and/or a signal that need/needs to be processed. The processor obtains the data and/or the signal from the communication interface, processes the data and/or the signal, and outputs a processing result through the communication interface. The communication interface may be an input/output interface.

Optionally, the processor and the memory may be physically independent units, or the memory may be integrated with the processor.

In another embodiment of this application, a communication system is further provided. The communication system includes a terminal device and a network device. For example, the terminal device may be the second communication apparatus in the foregoing embodiments, and the network device may be the first communication apparatus in the foregoing embodiments.

A person of ordinary skill in the art may understand that all or some of the processes of the methods in embodiments may be implemented by a computer program instructing relevant hardware. The program may be stored in a computer-readable storage medium. When the program is executed, the processes of the method embodiments are performed. The foregoing storage medium includes any medium that can store program code, such as a ROM, a random access memory RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A channel coding method, comprising:
determining, by a first communication apparatus, a first channel coding mode based on a first parameter, wherein the first parameter comprises one or more of a coding parameter, a service type, a device type, a coding feature, a modulation and coding scheme MCS, or a transport block size TBS;
performing, by the first communication apparatus, channel coding on a to-be-sent sequence by using the first channel coding mode, to obtain a coding sequence obtained after the channel coding; and
sending, by the first communication apparatus, the coding sequence.

2. The method according to claim 1, wherein the method further comprises:
sending, by the first communication apparatus, a first message, wherein the first message indicates the first channel coding mode.

3. A channel decoding method, comprising:
receiving, by a second communication apparatus, a coding sequence;
obtaining, by the second communication apparatus, a first channel coding mode, wherein the first channel coding mode is determined based on a first parameter, and the first parameter comprises one or more of a coding parameter, a service type, a device type, a coding feature, a modulation and coding scheme MCS, or a transport block size TBS; and
performing, by the second communication apparatus, channel decoding on the coding sequence by using the first channel coding mode, to obtain a sequence obtained after the channel decoding.

4. The method according to claim 3, wherein the obtaining, by the second communication apparatus, a first channel coding mode comprises:
receiving, by the second communication apparatus, a first message, wherein the first message indicates the first channel coding mode.

5. The method according to claim 1 or 2, wherein the first parameter comprises the coding parameter, and the coding parameter comprises one or more of a code length, an information bit length, a latency, or an error floor; and
the determining, by a first communication apparatus, a first channel coding mode based on a first parameter comprises:
determining, by the first communication apparatus, the first channel coding mode based on a mapping relationship between a coding parameter and a channel coding mode and the coding parameter obtained by the first communication apparatus, wherein
the coding parameter obtained by the first communication apparatus comprises a code length determined by the first communication apparatus, an information bit length of the to-be-sent sequence, or a requirement of the first communication apparatus for the error floor or a size of the latency.

6. The method according to claim 3 or 4, wherein the first parameter comprises the coding parameter, and the coding parameter comprises one or more of a code length, an information bit length, a latency, or an error floor; and
the obtaining, by the second communication apparatus, a first channel coding mode comprises:
determining, by the second communication apparatus, the first channel coding mode based on a mapping relationship between a coding parameter and a channel coding mode and the coding parameter obtained by the second communication apparatus, wherein
the coding parameter obtained by the second communication apparatus comprises a code length of the coding sequence, an information bit length of a to-be-sent sequence, or a requirement of a first communication apparatus for the error floor or a size of the latency.

7. The method according to claim 5 or 6, wherein the mapping relationship between a coding parameter and a channel coding mode comprises at least one of the following cases:
when a value of the coding parameter is less than or equal to a first coding parameter threshold, the channel coding mode is a first coding mode;
when a value of the coding parameter is greater than the first coding parameter threshold and less than a second coding parameter threshold, the channel coding mode is a second coding scheme; or
when a value of the coding parameter is greater than or equal to the second coding parameter threshold, the channel coding mode is a third coding mode.

8. The method according to claim 7, wherein if the coding parameter is the code length or the information bit length,
the first coding mode is any one of a Reed-Muller RM code, a BCH code, or a Reed-Solomon RS code;
the second coding mode is a Polar Polar code or a Turbo product code-Polar code TPC-Polar code; and
the third coding mode is any one of a low-density parity-check code LDPC code, a coupled LDPC code, or a coupled Polar code.

9. The method according to claim 7, wherein if the coding parameter is the latency, and the latency is an end-to-end latency or a decoding latency,
the first coding mode is an RM code or a BCH code;
the second coding mode is a Polar code or an LDPC code; and
the third coding mode is a Turbo code Turbo code or a Polar code.

10. The method according to claim 7, wherein if the coding parameter is the error floor,
the first coding mode is a Polar code or a BCH code;
the second coding mode is an LDPC code; and
the third coding mode is a Turbo code.

11. The method according to claim 1 or 2, wherein the first parameter comprises the service type, and the service type comprises one or more of an enhanced mobile broadband eMBB service, an ultra-reliable low-latency communication URLLC service, a massive machine type communication mMTC service, an ultra high throughput service, an autonomous driving service, or an industrial network service; and
the determining, by a first communication apparatus, a first channel coding mode based on a first parameter comprises:
determining, by the first communication apparatus, the first channel coding mode based on a mapping relationship between a service type and a channel coding mode and a service type to which the to-be-sent sequence belongs.

12. The method according to claim 3 or 4, wherein the first parameter comprises the service type, and the service type comprises one or more of an enhanced mobile broadband eMBB service, an ultra-reliable low-latency communication URLLC service, a massive machine type communication mMTC service, an ultra high throughput service, an autonomous driving service, or an industrial network service; and
the obtaining, by the second communication apparatus, a first channel coding mode comprises:
determining, by the second communication apparatus, the first channel coding mode based on a mapping relationship between a service type and a channel coding mode and a service type to which the coding sequence belongs.

13. The method according to claim 11 or 12, wherein the mapping relationship between a service type and a channel coding mode comprises at least one of the following cases:
when the service type is the eMBB service, the channel coding mode is an LDPC code or a Polar code;
when the service type is the URLLC service, the channel coding mode is a BCH-Polar code or a Golay code Golay code;
when the service type is the mMTC service, the channel coding mode is any one of a tail-biting convolutional code TBCC, a Polar code, or a BCH code;
when the service type is the ultra high throughput service, the channel coding mode is any one of a TPC-Polar code, a G_{N}-coset code, or an LDPC code;
when the service type is the autonomous driving service, the channel coding mode is a BCH-Polar code; or
when the service type is the industrial network service, the channel coding mode is any one of an RM code, a BCH code, or an RS code.

14. The method according to claim 1 or 2, wherein the first parameter comprises the device type;
the method further comprises:
receiving, by the first communication apparatus, a second message, wherein the second message indicates a device type of a second communication apparatus; and
the determining, by a first communication apparatus, a first channel coding mode based on a first parameter comprises:
determining, by the first communication apparatus based on a mapping relationship between a device type and a channel coding mode, the first channel coding mode corresponding to a device type of the first communication apparatus.

15. The method according to claim 3 or 4, wherein the first parameter comprises the device type;
the method further comprises:
sending, by the second communication apparatus, a second message, wherein the second message indicates a device type of the second communication apparatus; and
the obtaining, by the second communication apparatus, a first channel coding mode comprises:
determining, by the second communication apparatus based on a mapping relationship between a device type and a channel coding mode, the first channel coding mode corresponding to a device type of the first communication apparatus.

16. The method according to claim 14 or 15, wherein the mapping relationship between a device type and a channel coding mode comprises at least one of the following cases:
when the device type is an active device, the channel coding mode is an LDPC code or a Polar code;
when the device type is a passive device, the channel coding mode is a short sequence or a short cyclic code;
when the device type is a low power consumption device, the channel coding mode is any one of a TBCC, a Polar code, or a BCH code;
when the device type is a high throughput device, the channel coding mode is any one of a TPC-Polar code, a G_{N}-coset code, or an LDPC code;
when the device type is a high-reliable device, the channel coding mode is any one of a Polar code, a BCH code, or an RS code; or
when the device type is a low-latency device, the channel coding mode is any one of a Polar code, a BCH code, an RS code, or an LDPC code.

17. The method according to claim 1 or 2, wherein the first parameter comprises the coding feature, and the method further comprises:
receiving, by the first communication apparatus, a third message, wherein the third message indicates a coding feature supported by a second communication apparatus, and the coding feature comprises one or more of a hybrid automatic repeat request HARQ, an outer erasure code, or network coding; and
the determining, by a first communication apparatus, a first channel coding mode based on a first parameter comprises:
generating, by the first communication apparatus based on the coding feature supported by the second communication apparatus, the first channel coding mode that meets the coding feature.

18. The method according to claim 3 or 4, wherein the first parameter comprises the coding feature;
the method further comprises:
sending, by the second communication apparatus, a third message, wherein the third message indicates a coding feature supported by the second communication apparatus, and the coding feature comprises one or more of a HARQ, an outer erasure code, or network coding; and
the obtaining, by the second communication apparatus, a first channel coding mode comprises:
generating, by the second communication apparatus based on the coding feature supported by the second communication apparatus, the first channel coding mode that meets the coding feature.

19. The method according to claim 1 or 2, wherein the first parameter comprises the MCS or the TBS; and the determining, by a first communication apparatus, a first channel coding mode based on a first parameter comprises:
determining, by the first communication apparatus, the first channel coding mode based on a mapping relationship between an MCS index or a TBS index and a channel coding mode and an MCS index or a transport block size index determined by the first communication apparatus.

20. The method according to claim 3 or 4, wherein the first parameter comprises the MCS or the TBS; and
the obtaining, by the second communication apparatus, a first channel coding mode comprises:
determining, by the second communication apparatus, the first channel coding mode based on a mapping relationship between an MCS index or a TBS index and a channel coding mode and an MCS or a transport block size indicated by a first communication apparatus.

21. The method according to claim 19 or 20, wherein the first message is the MCS index or the TBS index; and the mapping relationship between an MCS index or a TBS index and a channel coding mode comprises at least one of the following cases:
when the MCS index or the TBS index is in a first interval, the channel coding mode is any one of a Simplex Simplex code, an RM code, or a BCH code;
when the MCS index or the TBS index is in a second interval, the channel coding mode is a TBCC or a BCH-Polar code;
when the MCS index or the TBS index is in a third interval, the channel coding mode is a Polar code;
when the MCS index or the TBS index is in a fourth interval, the channel coding mode is an LDPC code; or
when the MCS index or the TBS index is in a fifth interval, the channel coding mode is a TPC-Polar code or a coupled Polar code, wherein
the first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval.

22. A communication apparatus, specifically a first communication apparatus, comprising:
a determining module, configured to determine a first channel coding mode based on a first parameter, wherein the first parameter comprises one or more of a coding parameter, a service type, a device type, a coding feature, a modulation and coding scheme MCS, or a transport block size TBS;
a channel coding module, configured to perform channel coding on a to-be-sent sequence by using the first channel coding mode, to obtain a coding sequence obtained after the channel coding; and
a transceiver module, configured to send the coding sequence.

23. The communication apparatus according to claim 22, wherein the transceiver unit is further configured to send a first message, wherein the first message indicates the first channel coding mode.

24. A communication apparatus, specifically a second communication apparatus, comprising:
a transceiver module, configured to receive a coding sequence;
an obtaining module, configured to obtain a first channel coding mode, wherein the first channel coding mode is determined based on a first parameter, and the first parameter comprises one or more of a coding parameter, a service type, a device type, a coding feature, a modulation and coding scheme MCS, or a transport block size TBS; and
a channel decoding module, configured to perform channel decoding on the coding sequence by using the first channel coding mode, to obtain a sequence obtained after the channel decoding.

25. The communication apparatus according to claim 24, wherein the obtaining module comprises a receiving unit, configured to receive a first message, wherein the first message indicates the first channel coding mode.

26. The communication apparatus according to claim 22 or 23, wherein the first parameter comprises the coding parameter, and the coding parameter comprises one or more of a code length, an information bit length, a latency, or an error floor; and
the determining module is specifically configured to determine the first channel coding mode based on a mapping relationship between a coding parameter and a channel coding mode and the coding parameter obtained by the first communication apparatus, wherein
the coding parameter obtained by the first communication apparatus comprises a code length determined by the first communication apparatus, an information bit length of the to-be-sent sequence, or a requirement of the first communication apparatus for the error floor or a size of the latency.

27. The communication apparatus according to claim 24 or 25, wherein the first parameter comprises the coding parameter, and the coding parameter is any one of a code length, an information bit length, a latency, or an error floor; and
the obtaining module comprises a determining unit, configured to determine the first channel coding mode based on a mapping relationship between a coding parameter and a channel coding mode and the code length of the coding sequence, the information bit length of a to-be-sent sequence, or a requirement of a first communication apparatus for the error floor or a size of the latency.

28. The communication apparatus according to claim 26 or 27, wherein the mapping relationship between a coding parameter and a channel coding mode comprises at least one of the following cases:
when a value of the coding parameter is less than or equal to a first coding parameter threshold, the channel coding mode is a first coding mode;
when a value of the coding parameter is greater than the first coding parameter threshold and less than a second coding parameter threshold, the channel coding mode is a second coding scheme; or
when a value of the coding parameter is greater than or equal to the second coding parameter threshold, the channel coding mode is a third coding mode.

29. The communication apparatus according to claim 28, wherein if the coding parameter is the code length or the information bit length,
the first coding mode is any one of a Reed-Muller RM code, a BCH code, or a Reed-Solomon RS code;
the second coding mode is a Polar Polar code or a Turbo product code-Polar code TPC-Polar code; and
the third coding mode is any one of a low-density parity-check code LDPC code, a coupled LDPC code, or a coupled Polar code.

30. The communication apparatus according to claim 28, wherein if the coding parameter is the latency, and the latency is an end-to-end latency or a decoding latency,
the first coding mode is an RM code or a BCH code;
the second coding mode is a Polar code or an LDPC code; and
the third coding mode is a Turbo code Turbo code or a Polar code.

31. The communication apparatus according to claim 28, wherein if the coding parameter is the error floor,
the first coding mode is a Polar code or a BCH code;
the second coding mode is an LDPC code; and
the third coding mode is a Turbo code.

32. The communication apparatus according to claim 22 or 23, wherein the first parameter comprises the service type, and the service type comprises one or more of an eMBB service, an URLLC service, an mMTC service, an ultra high throughput service, an autonomous driving service, or an industrial network service; and
the determining module is specifically configured to determine the first channel coding mode based on a mapping relationship between a service type and a channel coding mode and a service type to which the to-be-sent sequence belongs.

33. The communication apparatus according to claim 24 or 25, wherein the first parameter comprises the service type, and the service type comprises one or more of an eMBB service, an URLLC service, an mMTC service, an ultra high throughput service, an autonomous driving service, or an industrial network service; and
the obtaining module comprises a determining unit, configured to determine the first channel coding mode based on a mapping relationship between a service type and a channel coding mode and a service type to which the coding sequence belongs.

34. The communication apparatus according to claim 32 or 33, wherein the mapping relationship between a service type and a channel coding mode comprises at least one of the following cases:
when the service type is the eMBB service, the channel coding mode is an LDPC code or a Polar code;
when the service type is the URLLC service, the channel coding mode is a BCH-Polar code or a Golay code Golay code;
when the service type is the mMTC service, the channel coding mode is any one of a tail-biting convolutional code TBCC, a Polar code, or a BCH code;
when the service type is the ultra high throughput service, the channel coding mode is any one of a TPC-Polar code, a G_{N}-coset code, or an LDPC code;
when the service type is the autonomous driving service, the channel coding mode is a BCH-Polar code; or
when the service type is the industrial network service, the channel coding mode is any one of an RM code, a BCH code, or an RS code.

35. The communication apparatus according to claim 22 or 23, wherein the first parameter comprises the device type;
the transceiver module is further configured to receive a second message, wherein the second message indicates a device type of a second communication apparatus; and
the determining module is specifically configured to determine, based on a mapping relationship between a device type and a channel coding mode, the first channel coding mode corresponding to a device type of the first communication apparatus.

36. The communication apparatus according to claim 24 or 25, wherein the first parameter comprises the device type;
the transceiver module is further configured to send a second message, wherein the second message indicates a device type of the second communication apparatus; and
the obtaining module comprises a determining unit, configured to determine, based on a mapping relationship between a device type and a channel coding mode, the first channel coding mode corresponding to a device type of the first communication apparatus.

37. The communication apparatus according to claim 35 or 36, wherein the mapping relationship between a device type and a channel coding mode comprises at least one of the following cases:
when the device type is an active device, the channel coding mode is an LDPC code or a Polar code;
when the device type is a passive device, the channel coding mode is a short sequence or a short cyclic code;
when the device type is a low power consumption device, the channel coding mode is any one of a TBCC, a Polar code, or a BCH code;
when the device type is a high throughput device, the channel coding mode is any one of a TPC-Polar code, a G_{N}-coset code, or an LDPC code;
when the device type is a high-reliable device, the channel coding mode is any one of a Polar code, a BCH code, or an RS code; or
when the device type is a low-latency device, the channel coding mode is any one of a Polar code, a BCH code, an RS code, or an LDPC code.

38. The communication apparatus according to claim 22 or 23, wherein the first parameter comprises the coding feature, and the transceiver module is further configured to receive a third message, wherein the third message indicates a coding feature supported by a second communication apparatus, and the coding feature comprises one or more of a HARQ, an outer erasure code, or network coding; and
the determining module is specifically configured to generate, based on the coding feature supported by the second communication apparatus, the first channel coding mode that meets the coding feature.

39. The communication apparatus according to claim 24 or 25, wherein the first parameter comprises the coding feature;
the transceiver module is further configured to send a third message, wherein the third message indicates a coding feature supported by the second communication apparatus, and the coding feature comprises one or more of a HARQ, an outer erasure code, or network coding; and
the obtaining module comprises a determining unit, configured to generate, based on the coding feature supported by the second communication apparatus, the first channel coding mode that meets the coding feature.

40. The communication apparatus according to claim 22 or 23, wherein the first parameter comprises the MCS or the TBS; and
the determining module is specifically configured to determine the first channel coding mode based on a mapping relationship between an MCS index or a TBS index and a channel coding mode and an MCS index or a transport block size index determined by the first communication apparatus.

41. The communication apparatus according to claim 24 or 25, wherein the first parameter comprises the MCS or the TBS; and
the obtaining module comprises a determining unit, configured to determine the first channel coding mode based on a mapping relationship between an MCS index or a TBS index and a channel coding mode and an MCS or a transport block size indicated by a first communication apparatus.

42. The communication apparatus according to claim 40 or 41, wherein the first message is the MCS index or the TBS index; and
the mapping relationship between an MCS index or a TBS index and a channel coding mode comprises at least one of the following cases:
when the MCS index or the TBS index is in a first interval, the channel coding mode is any one of a Simplex Simplex code, an RM code, or a BCH code;
when the MCS index or the TBS index is in a second interval, the channel coding mode is a TBCC or a BCH-Polar code;
when the MCS index or the TBS index is in a third interval, the channel coding mode is a Polar code;
when the MCS index or the TBS index is in a fourth interval, the channel coding mode is an LDPC code; or
when the MCS index or the TBS index is in a fifth interval, the channel coding mode is a TPC-Polar code or a coupled Polar code, wherein
the first interval, the second interval, the third interval, the fourth interval, and the fifth interval do not overlap each other, a maximum value of the first interval is less than or equal to a minimum value of the second interval, a maximum value of the second interval is less than or equal to a minimum value of the third interval, a maximum value of the third interval is less than or equal to a minimum value of the fourth interval, and a maximum value of the fourth interval is less than or equal to a minimum value of the fifth interval.

43. A communication apparatus, comprising a processor, configured to execute a computer program or instructions stored in a memory, so that the communication apparatus performs the method according to any one of claims 1 to 21.

44. The communication apparatus according to claim 43, wherein the communication apparatus further comprises the memory and/or a transceiver, and the transceiver is configured to receive and send a signal.

45. A computer program product comprising program instructions, wherein when the program instructions are run on a computer, the computer is enabled to perform the method according to any one of claims 1 to 21.

46. A computer-readable storage medium, wherein the computer-readable storage medium stores program instructions; and when the program instructions are run, the method according to any one of claims 1 to 21 is performed.

47. An apparatus, wherein the apparatus comprises a processor and a communication interface, the communication interface is configured to receive and send a signal, and the processor is configured to read and execute a program stored in a memory, so that the method according to any one of claims 1 to 21 is performed.

48. A communication system, comprising the communication apparatus according to any one of claims 22 to 42.
